# EUROPEAN PATENT SPECIFICATION

(11) **EP 0 419 461 B1**
(45) Date of publication and mention of the grant of the patent: **02.09.1998**
(21) Application number: 88906447.3
(22) Date of filing: 17.06.1988
(51) Int. Cl.: H01J 37/20, B25J 9/10, B25J 19/00, B25J 21/00, H01L 21/00

(54) **WAFER HANDLING SYSTEM WITH BERNOULLI PICK-UP**
SILICIUMWAFER-HANDHABUNGSSYSTEM MIT BERNOULLI-AUFNAHME
SYSTEME DE MANUTENTION DE TRANCHES DE SILICIUM A RAMASSAGE DE TYPE BERNOULLI

(43) Date of publication of application: 03.04.1991
(73) Proprietor: ADVANCED SEMICONDUCTOR MATERIALS AMERICA, INC., Phoenix, Arizona 85034 (US)
(72) Inventor: GOODWIN, Dennis, L., Phoenix, Arizona 85044 (US); CRABB, Richard, Messa, AZ 85201 (US); ROBINSON, McDonald, Goleta, California 93117 (US); FERRO, Armand, P., Scottsdale, AZ 85251 (US)
(74) Representative: Wächtershäuser, Günter, Prof. Dr.
(86) International application number: US8802115
(87) International publication number: WO8912907

(56) References cited:
- DE-A- 3 642 937
- US-A- 3 539 216
- US-A- 3 981 687
- US-A- 4 029 351
- US-A- 4 391 773
- US-A- 4 440 553
- US-A- 4 553 069
- US-A- 4 574 004
- IBM TECHNICAL DISCLOSURE BULLETIN, vol. 22, no. 8A, January 1980, pages 3370- 3371, Armonk, NY, US; R.D. COLES: "Self-centering non-contact pick-up"

## Description

### BACKGROUND OF THE INVENTION

### Field of the Invention

This invention relates generally to wafer handling apparatus for use in a semiconductor processing system and, more particularly to an improved wafer handling system using a pair of articulated robot arms carrying a pick-up wand for lifting wafers without contact with the top or bottom surfaces of the wafer.

### Description of the Prior Art

Many different types of semiconductor processing systems require the use of wafer handling systems or wafer transport mechanisms. Chemical Vapor Deposition (CVD) is the formation of a stable compound on a heated substrate by the thermal reaction or deposition of various gaseous compounds. Chemical Vapor Deposition may be accomplished in many ways, but all types of CVD equipment include a reaction chamber, a gas control section, a timing and sequence control component, a heat source for the substrates, and a means for handling the reacted gases. Epitaxial deposition is the deposition of a single crystal layer on a substrate (often, but not always, of the same composition as the deposited layer), such that the crystal structure of the layer is an extension of the crystal structure of the substrate. Another example of Chemical Vapor Deposition is generally classified as "metallization" which can be performed using any one of several types of deposition reactions. In metallization, the processed silicon substrates have the metal connectors and the like deposited thereon.

A further semiconductor processing category involves ion implantation. This process selects ions of a desired dopant and accelerates them using an electrical field, and then scans them across the face or surface of a wafer to obtain a uniform predeposition. Semiconductor processes, in general, include photo-processing systems, inspection systems, cleaning systems, and all types of processes referred to herein collectively as semiconductor processing systems. One feature of all such systems, is that some means must be provided for carrying or transporting the individual semiconductor wafer disks, wafers, or substrates from an input station to a reactor or similar processing station. Most often, the transport mechanism is then used to transport the device from the processing station back to a storage location. Batch processing systems involve the deposition of more than one substrate or wafer at a time. Such systems are normally hand-loaded and the wafers are carried in boats. The boats are usually loaded and unloaded as by use of tweezers, hand-held vacuum pick-ups, and the like. Mass transfer of multiple wafers is also done using loading robots. In batch processing reactors containing many of today's larger wafers, achieving acceptable uniformity over the large surfaces is very difficult.

While such batch systems have been used extensively int he prior art, a modern trend is toward the use of single wafer processing systems. Single wafer processing systems are more desirable since the modern trend in integrated circuit technology is toward the processing of ever larger semiconductor wafers. Wafers having diameters of over 12 inches are currently being used. These larger wafers can contain many more circuits and much more complex circuits than were heretofore possible in the prior art. While single wafer systems have less throughput than batch reactor systems, attempts are being made to speed up the single wafer processes, to develop higher yields, to avoid problems such as particle contamination and the like and to increase uniformity and quality.

Most of the prior art single wafer transport mechanisms can be used in various types of semiconductor processing systems. For example, the prior art teaches a gravity feed wafer transport system wherein the wafers to be processed are stacked in a supply receptacle. The receptacle is supported in an elevator at an angle to vertical so that a wafer within the boat is free to slide out and along an inclined ramp to the vacuum mandrel. A plate is used to prevent all but one of the wafers from leaving the supply receptacle at a given time. Another inclined ramp is provided, so that once the wafer is processed, it slides down the ramp into a receiving receptacle which is also at an angle to the vertical. The disadvantages of this type of system include the fact that there is not positive feed; the material placed onto the wafer can come off on the sliding ramps; contaminating particles are generated by the sliding surfaces; and it can be used with only a single size wafer; etc.

Other types of semi-automatic system for transporting wafers to and from the processing area utilizes air-bearings. Once again the wafers are stored in receptacles. The wafers are maintained horizontally and are transported to and from the processing area by means of an air bearing, i.e. upon a cushion of air. Like the gravity feed system, this type of mechanism has proved to be highly unreliable and includes many moving parts subject to breakage and maintenance down-time. Again, foreign material may get into the air bearings and damage them or reduce their effectiveness. Other systems utilize air cushion guidance means where the problem of cleanliness of the air and of the turbulence produced by the air cushion are quite significant. The settling of dirt particles onto the top surface of the wafers are difficult to avoid in such systems. Further, such systems utilize lateral guard rails, and contact between the edges of the wafer and the guard rails occurs frequently, resulting in unacceptable contamination or damage to the wafers and a reduction of the wafer yield. Further, only one size of wafer can be handled without significant modification and a system cannot operate during the time that the wafer receptacles are being replaced manually.

Still another type of system uses a combination of supply slides and receiving slides together with a rotating carousel. Yet another system uses driven belt transport during the discharge from the supply cassette and at various other transfer points. As the cassettes are discharged successively from the bottom and loaded in reverse order, impurities often drop from the bottom side of one wafer onto the top side of the wafer beneath it. Additional problems arise at the transfer points because the transport motion of the wafers is terminated by stoppers which can result in previously deposited layers being spalled or chipped off to further contaminate the surface.

Still other wafer handling systems utilize a spatula or shovel-type pick-up, often mounted on the end of a linearly positionable arm. These devices slide under the wafers or move under the wafers and come up through the cassette track spaces to pick-up the wafers and physically carry them to the next location. Examples of such systems are shown in U.S. Patent No. 4,553,069 which issued on November 12, 1985 to Kenneth W. Purser and which incorporates by reference the robot arm-type wafer handling system referred to as the ORBITRAN™ HANDLER manufactured by Brooks Associates, Inc.

Still other arm-type systems utilize a vacuum chuck which is positioned under the wafer and which attaches to the underside of the wafer by producing a vacuum and then lifts the wafer out of the cassette prior to carrying it to a processing station or the like. These systems can't place a wafer on a flat continuous surface due to their use of bottom handling. Again, damage often results from the mechanical cont act between the vacuum pick-up head and the underside of the wafer, and contact also results in removing the wafer from the cassette holder resulting in decreased yield and injury to the wafer itself. Still further, small airborne particles can easily settle onto the top surface of the wafer for reducing yield and destroying circuit integrity, since the elevators containing the cassettes are a prime source of system contamination.

Prior art patents which teach or show various types of wafer transport mechanisms include U.S. Patent No. 2,294,273 which issued to E. K. Buxbaum on August 15, 1942; U.S. Patent No. 2,881,499 which issued to E. R. Guzmer on June 21, 1960; U.S. Patent No. 2,881,929 which issued to J. LowGiffen on April 14, 1959; U.S. Patent No. 2,185,089 which issued to A. L. Kronquist on December 26, 1939; U.S. Patent No. 3,552,584 which issued to R. J. Heinrich on June 5, 1971; U.S. Patent No. 3,516,386 which issued to G. L. Lanewehr et al on June 23, 1970; U.S. Patent No. 3,823,836 which issued to O. F. Sheney et al on December 16, 1974; U.S. Patent No. 3,874,525 which issued to J. K. Hassan et al on April 1, 1975; U.S. Patent No. 3,921,788 which issued to G. A. Robertson Jr. et al on November 25, 1975; U.S. Patent No. 4,047,624 which issued to F. W. Dorenbos on September 13, 1977; U.S. Patent No. 4,501,527 which issued to H. D. Jacoby et al on September 26, 1985; and U.S. Patent No. 4,553,069 which issued to K. H. Purser on November 12, 1985.

U.S. Patent No. 4,029,351, issued to Apgar et al discloses a pickup head for semiconductor wafers which has a vertical central aperture through which gas is expelled to create Bernoulli's effect thereunder for lifting wafers. Three auxiliary ports oriented at 120-degree locations around the central aperture discharge gas downward to the periphery of the wafer to apply a restoring torque thereto. The auxiliary ports are recessed to minimize or mitigate the lift on the wafer they produce.

U.S. Patent No. 3,539,216, issued to Forcier, discloses a pickup device for semiconductor wafers which includes a lower surface having a pair of ports therein. A centrally disposed port extending perpendicular to the lower plate directs gas toward the wafer to provide a low-pressure environment above the wafer, creating lift. A second port is inclined at an acute angle to the underside of the device and provides an unbalanced flow in the direction of two depending members or stops. The unbalanced flow emitted between the center of the workpiece and the stops provides a rotational torque on the wafer so that the edge of the wafer adjacent the stops is urged upward to securely hold the wafer against the stops.

In summary, the trend of the prior art is toward single wafer processing systems, and a key factor in automating such systems to increase productivity lies in improving the wafer handling system or transport mechanism used for transferring the wafers from station to station. Furthermore, the critical problems presented by particle contamination becomes evermore important as wafers become larger and larger and circuits become more and more complex, since a single particle on a complex circuit can destroy the circuit and result in expensive damage and yield reduction.

None of the prior art systems are sufficiently clean to enable their use in a completely automated, single wafer processing system. None avoid touching the top and/or bottom surfaces of the wafer, thereby extremely limiting their application. The problem of contacting the wafer with various other apparatus of the system results in damage to the top and/or bottom surfaces of the wafer, particle contamination from chipped off portions etc., particle contamination from the handling system itself, and the like.

The wafer handling system of the present invention solves or at least greatly improves upon contamination of the problems of the prior art while avoiding many of its shortcomings.

### Summary of the Invention

The present invention provides a wafer handling and transport apparatus for lifting and retaining a wafer having opposed top and bottom surfaces and a wafer perimeter, without physically contacting the top or bottom surfaces of the wafer. The apparatus transports the wafer from a first location to a second location utilizing a source of gas and a pickup wand assembly supported by at least one arm. The apparatus is characterized by the pickup wand assembly having a lower plate with a generally planar lower surface and a gas distribution path within the wand assembly. The lower plate includes at least one first outlet centrally disposed therein and oriented essentially normal thereto for receiving gas from the gas source through the gas distribution path, and expelling the gas from the lower surface to develop a low-pressure environment above the wafer and establish an omni-directional flow of gas across the wafer upon retention of the wafer. The lower plate further includes a plurality of second outlets disposed therein and arranged in a predetermined pattern for receiving gas from the gas source through the gas distribution path, and expelling the gas from the lower surface to develop a low-pressure environment above the wafer and establish a plurality of gas streams toward the perimeter of the wafer. The plurality of second outlets includes at least one oriented generally toward the arm and at least one oriented generally away from the arm, and is arranged to expel more gas toward the arm than away from the arm to impart a net frictional force on the wafer in the direction of the arm.

The present invention also provides a method of lifting and transporting a wafer, the wafer having a top surface, a bottom surface, and a perimeter. The method transports the wafer from a first location to a second location without physically contacting the top or bottom surfaces of the wafer utilizing a source of gas. The method is characterized by the steps of supporting a pickup wand assembly with at least one arm, the wand assembly having a lower plate with a generally planar lower surface. At least one first outlet is disposed centrally in and oriented normal to the lower surface, and a plurality of second outlets is disposed in the lower surface and arranged in a predetermined pattern wherein at least one outlet is oriented generally toward the arm and at least one outlet is oriented generally away from the arm. The method includes communicating the gas from the source of gas to the first and second outlets through a gas distribution path within the wand assembly and expelling gas from the first and second outlets. Gas expelled from the first outlet develops a low-pressure environment above the wafer and establishes an omni-directional flow of gas across the wafer. Gas expelled from the second outlets develops a low-pressure environment above the wafer and establishes a plurality of streams of gas flow toward the perimeter of the wafer. More gas is expelled toward the arm than away from the arm to impart a net frictional force on the wafer in the direction of the arm.

It is an object of the present invention to provide an improved wafer handling system for use in semiconductor processing systems.

It is another object of the present invention to provide a wafer handling system employing a wafer pick-up wand utilizing the Bernoulli Principle.

It is a further object of the present invention to provide a wafer handling system utilizing a pick up wand for lifting a wafer from above while avoiding any physical contact therebetween.

It is yet another object of the present invention to provide a wafer handling system which greatly reduces particulate generation.

It is still another object of this invention to protect the top surface of the wafer from particulate contamination during pick up, transport, and drop off.

It is yet a further object of this invention to provide a wafer handling system having a Bernoulli pick up wherein the gas is supplied to the pick up through hollow passages within a pair of articulated robot arms.

It is still another object of this invention to provide a means for filtering particles from the gas as it passes through the robot arms.

It is another object of this invention to provide a robot arm pick up system which does not require vertical movement of the arms.

It is a further object of the present invention to provide a highly accurate wafer positioning system using DC micro-stepping motors.

It is yet another object of the present invention to provide a much stronger pair of robot arms for a wafer handling system so as to enable the arms to have a much longer reach than heretofore possible in wafer handling systems.

It is a further object of this invention to provide additional filtration for removing particles from the gas as the gas passes from the ends of the robot arms to the wand.

It is yet a further object of this invention to provide a geometric pattern of gas outlets and a geometric pattern of grooves for supplying gas to the outlets on a pick-up wand.

It is still a further object of this invention to provide a pattern of gas outlets on the bottom of a pick up wand for substantially, radially outwardly, directing the gas flow to provide for the creation of a low pressure area between the lower surface of the pick up wand and the upper surface of the wafer with respect tot he pressure beneath the wafer so as to enable the wafer to be picked up from above the top surface thereof without physical contact between the top surface of the wafer and the pick up wand, while simultaneously providing an outward flow of air which continually sweeps the surface of the wafer to prevent contamination from particles.

It is yet another object of the present invention to provide a pick up wand which, by means of a particular array or pattern of outwardly disposed gas outlets, creates an outward flow at all points on the wafer perimeter so as to avoid any vacuum effect that might pull or draw particulate contaminants from the surrounding chamber onto the wafer surface. The particular array or pattern of gas outlets further creates a gentle horizontal force on the wafer or substrate which tends to guide it to a rest position.

It is still another object of the present invention to provide a Bernoulli pick up device mounted to a pair of articulated robot arms in an enclosed wafer handling system for greatly reducing the presence of impurities and particles which might otherwise contaminate the wafer.

It is an object of the present invention to provide a wafer handling system having means for providing a controlled clean atmosphere therein.

It is another object of this invention to enable heated or hot wafer pick up without contaminating the wafer.

It is yet another object of the present invention to provide for charge neutralization of particles on and about the path of the wand.

It is still another object of this invention to provide easily interchangeable pick up wand heads to handle various sizes of wafers.

It is still a further object of this invention to provide a wafer pick up and transport mechanism which (1) picks up the wafer from above the top surface thereof while avoiding any physical contact between top surface of the wafer and the pick up wand except possibly for points on the wafers edge; (2) continuously sweeps particles off of the top surface of the wafer during pick up and transport operations; (3) eliminates particles which would otherwise result from the "vacuuming effect"; (4) utilizes a gas outlet array or pattern which provide a uniform pick up gap between the bottom of the wand and the top surface of the wafer; (5) completely eliminates or at least minimizes the chance of top surface of wafer-to-wand contact except for gentle contact of the wafer edge with the locating system.

The present invention provides a wafer handling system for picking up a wafer from one or more storage locations and delivering the wafer to one or more semiconductor processing locations. The storage and processing locations are different and distinct from one another. The wafer handling system includes an enclosure for operatively communicating with the first and second locations. A pair of articulated robot arms is provided with each of the arms having a rear end portion, a front end portion, and an intermediate portion therebetween which may have at least one articulated joint.

A pick-up wand assembly is operatively carried by the front end portion of the robot arms. The pick-up wand assembly includes means for picking up the wafer from above the top without actual physical contact between the wafer and the wand assembly, although some soft contact of the edges of the wafer against the stops occurs. Means are provided for operatively mounting the rear end portion of the robot arms for imparting motion thereto, and drive means are operatively coupled to the motion imparting means for retracting, extending, and rotating the robot arms for picking up and delivering wafers from location to location.

The pick up wand assembly of the present invention utilizes the Bernoulli pick up effecting a contactless pick up or lifting of the wafer. The system uses a source of gas under pressure and means for supplying the gas to the rear end portion of each of the robot arms. Each of the robot arms includes a continuous gas passage through the interior thereof for communicating the gas passing therethrough to the wand assembly. The wand assembly is mounted to the front end portion of the robot arms, and the wand assembly includes means for receiving and distributing the gas to the pick up means from the front end portion of the robot arms. The pick up means includes a plurality of gas outlets for producing an area of relatively low pressure between the top surface of the wafer and the bottom surface of the pick up wand assembly (with respect tot he pressure existing beneath the wafer) for lifting the wafer without physical contact between the wafer and the pick up wand assembly.

In the preferred embodiment, the pick up wand assembly includes a wafer pick up wand which includes a top gas distribution plate, a bottom wafer pick up plate, and the wafer stops. Each of the plates is generally planar, and each has a rear portion, a front end portion, and an intermediate, generally planar body portion. Each of the plates has a relatively flat top surface and a relatively flat bottom surface.

The top gas distribution plate includes a gas inlet aperture operatively disposed in the rear end portion thereof. The gas inlet aperture communicates the top of the top gas distribution plate with the gas outlet at the front end portion of the robot arms. The bottom pick up plate includes a predetermined geometric pattern of gas outlets operatively disposed about the intermediate body portion thereof. The bottom surface of the top gas distribution plate includes a common compartment for receiving gas from the gas inlet aperture and a plurality of grooves such as when the top plate is operatively disposed over and flush against the top surface of the bottom pick up plate, gas is distributed from the common compartment through the grooves to each of the gas outlets in the bottom pick up plate.

The plurality of gas outlets on the bottom plate are located on the boundary of the geometric pattern produced thereby and each of the gas outlets is oriented or slanted substantially radially outward from a central portion of the geometric pattern to produce an outward gas flow across the top surface of the wafer to be picked up or lifted which (1 creates or establishes an area or zone of relatively low pressure between the bottom surface of the pick up wand and the top surface of the wafer (relative to or with respect to the pressure normally existing beneath the lower surface of the wafer to enable a pick up from above the wafer without any physical contact between the wafer and the pick up wand; provides a continuous outward sweeping action which continually sweeps the top surface of the wafer free of particles which might otherwise accumulate; (3) provides a uniform pick up gap between the bottom surface of the pick up wand and the top surface of the wafer; (4) exerts a soft gentle horizontal force on the wafer for moving it toward the locator stops; and (5) avoids substantially all of the problems discussed previously with respect to the prior art.

An additional central relief aperture or gas outlet can be provided within the interior of the geometric pattern to further decrease turbulence and greatly reduce any chance of particle contamination which might otherwise result from the vacuuming effect". Furthermore, various patterns of gas outlets may be used including, for example, seven hole and nine hole versions which have been tested and proven successful.

Furthermore, the plates are preferably made from fused quartz and are acid-etched, preferably with hydrofluoric acid, to further reduce particle contamination. The use of fused quartz enables hot pick up within the reactor and enables the bombardment of the top surface of the wafer with UV radiation, through the wand, for charged particle neutralization. Filters may be provided within the robot arms for removing particles from the gases, and an additional final filter can be provided between the front end portion of the robot arms and the inlet too the top plate of the pick up wand for removing any remaining particles in the gas flow.

Additionally, the robot arms are much stronger than any previously produced due to the cylindrical cross section of the robot arms, the use of substantially all stainless steel in construction of the arms, and other factors which enable the robot arms of the present invention to have a much longer reach and greater positioning accuracy than heretofore possible in the prior art. The pick up wand heads are readily interchangeable to quickly and easily convert the system from one wafer size to another.

These and other objects and advantages of the present invention will be better understood after reading the Detailed Description of the Preferred Embodiment of the present invention, the claims, and the drawings, which are briefly described hereinbelow.

### Brief Description of the Drawings

Figure 1 is a perspective view, partially cut away, of the wafer handling system of the present invention as utilized in a semiconductor processing system;
Figure 2 is a partially sectional top plan view of the wafer handling system of Figure 1;
Figures 3A-3P show a series of illustrations depicting the movements of the robot arms of the wafer handling system of Figure 1;
Figure 4 is an assembly drawing of the drive system of the present invention;
Figure 5 is an assembly drawing of the fluidic drive portion of the drive system of Figure 4;
Figure 6 is a sectional top view of the gear drive portion of the drive system of Figure 4;
Figure 7 is a top view of the robot arms of the wafer handling system of Figure 1;
Figure 8 is a side view of one of the robot arms of Figure 7;
Figure 9 is a perspective view of the pickup wand assembly and mount of the wafer handling system of Figure 1;
Figure 10 is a sectional side view of the front end of the robot arms and the pickup mount of Figure 9;
Figure 11 is an assembly drawing illustrating the front ends of the robot arms, the mounting unit and the pickup wand of Figure 9;
Figure 12 is a bottom view of the top gas distribution plate of the wand unit of Figure 9;
Figure 13 is a sectional end view of the gas distribution plate shown in Figure 12;
Figure 14 is a sectional side view of the gas distribution plate shown in Figure 12;
Figure 15 is a top plan view of the plate shown in Figure 9;
Figure 16 is a sectional side view of one of the gas outlets shown in Figure 15;
Figure 17 is a sectional side view of a gas outlet shown in Figure 15;
Figure 18 is a partial sectional side view showing an apparatus for further reducing particle contamination; and
Figure 19 is a partial sectional side view showing apparatus for particle elimination.

### Detailed Description of the Preferred Embodiment

Although the wafer handling system of the present invention will be described as it is used in a semiconductor processing system, and more specifically, as it is used in an epitaxial deposition system, it will be understood that it can be used in any type of semiconductor processing system, including, but not limited to, those previously described.

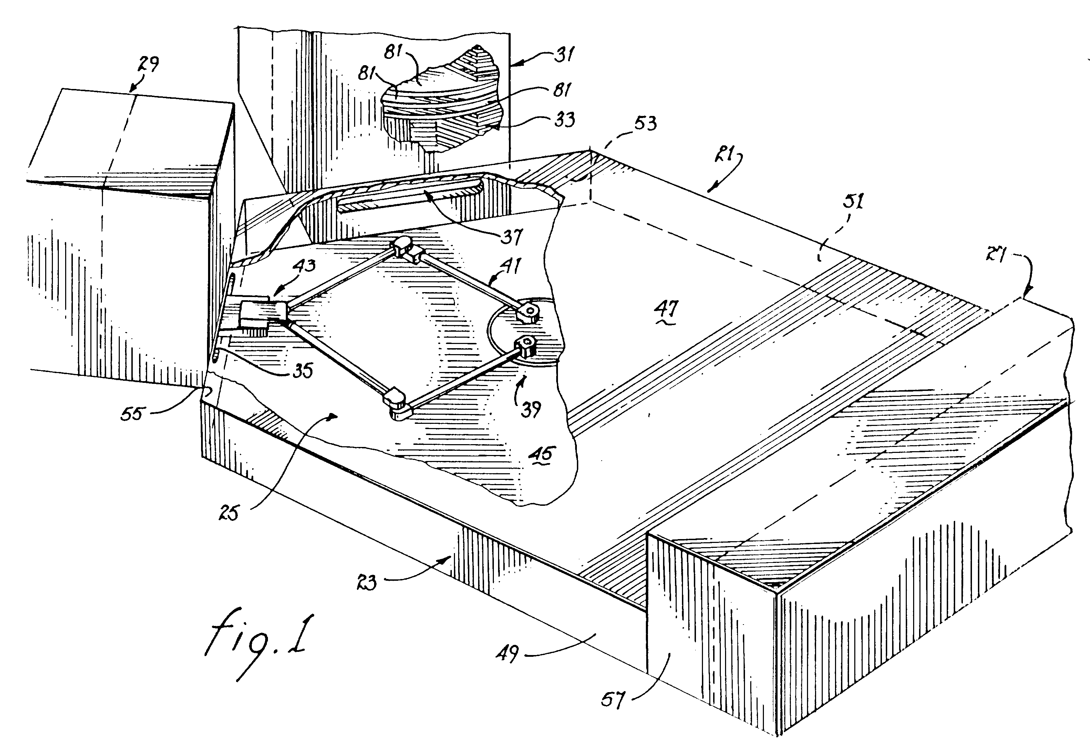

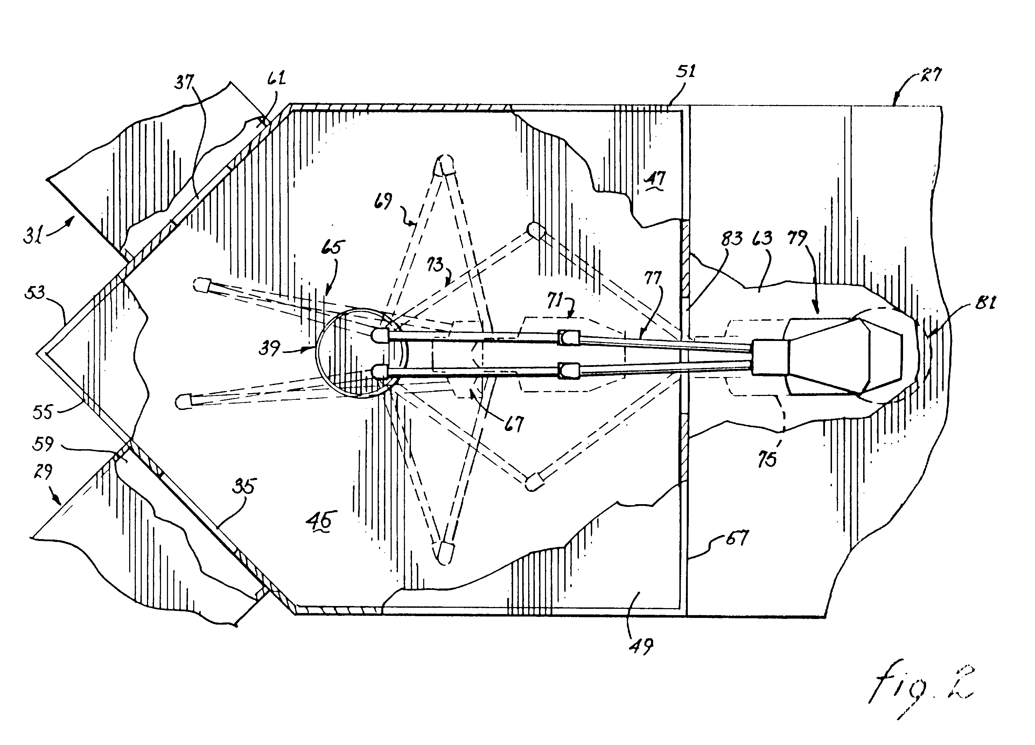

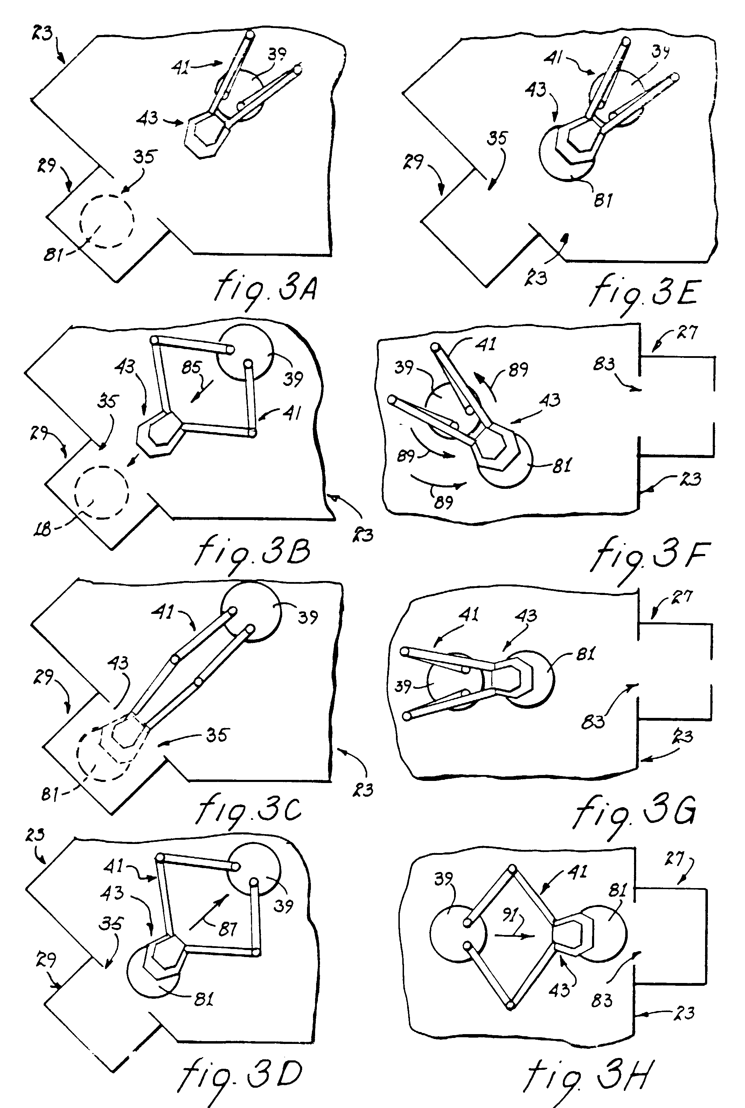

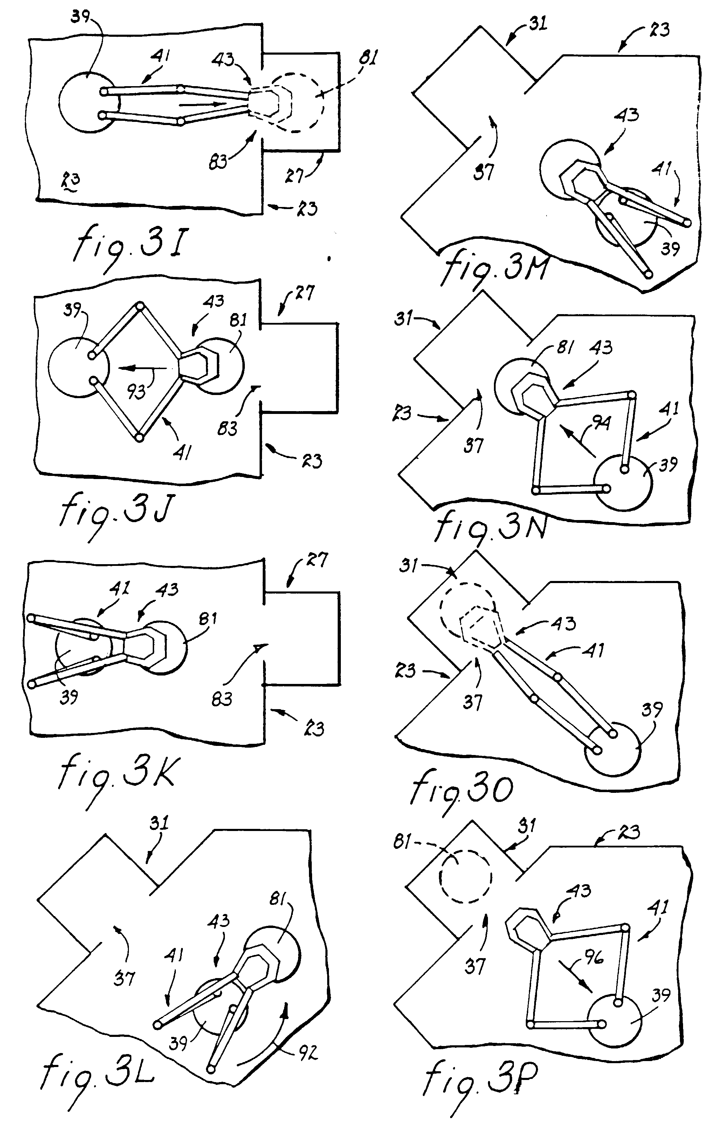

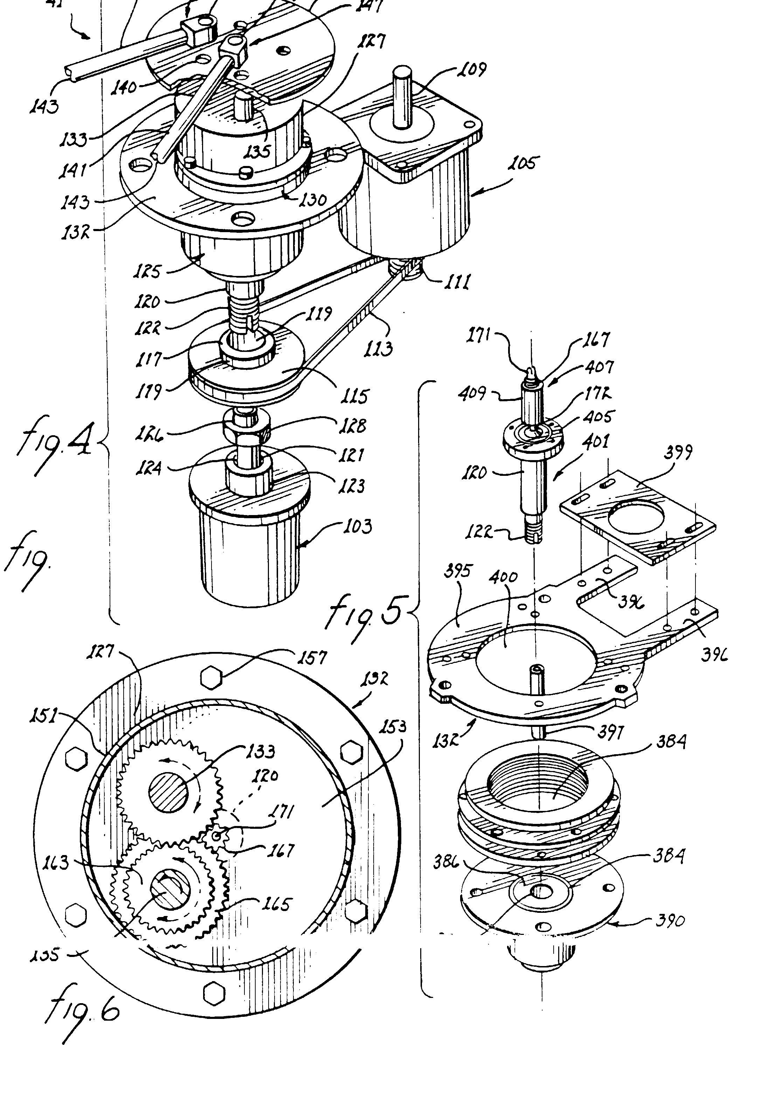

Figure 1 shows a wafer handling system 21 including a laminar flow envelope or enclosure 23 having a substantially hollow interior 25. Preferably, the envelope 23 is made of a non contaminating material such as anodized aluminum.

The epitaxial deposition system in which the wafer or substrate handling system 21 is described, in the preferred embodiment of the present invention, includes a reactor oven, reaction chamber, or reactor 27 having an access opening, gate, or slot 83 communicating the hollow interior 25 of the envelope 23 with the hollow interior 63 of the reaction chamber 27. A gate valve is provided for selectably opening or sealably closing the access slot 83.

The epitaxial deposition system herein described also includes at least two stations, purge boxes, or material loading/unloading ports 29, 31 for supplying wafers 81 to be processed, respectively. Each of the ports 29, 31 includes a hollow interior and an access slot 35, 37, respectively, for communicating the hollow interior 25 of the wafer handling envelope 23 with the hollow interior of the ports 29, 31. Each port 29, 31 also includes, housed within the hollow interior thereof, a cassette 33 which sits on an indexing elevator. Each cassette 33 includes plurality of vertically stacked tracts which support the substrates or wafers on their outermost peripheral edges and with a horizontal orientation. Each wafer may be, for example, a six inch circular silicon wafer which is to have additional silicon deposited thereon. Each purge box 29, 31 also has an access door (not shown) on the side opposite the slot 35, 37 for human operator access for loading and unloading the cassettes.

The specific structures of the purge boxes or ports 29, 31, the cassettes 33, the wafers 81, the elevators, the elevator indexing mechanisms, the purging system, and the like are not critical to an understanding of the present invention, and will not be described in any greater detail herein.

An arm mounting plate assembly 39 is disposed in a central recess in the floor 45 of the envelope 23 and is used to operatively mount the rear end portion of a pair of robot arms 41 thereto. The combination of the rotatable plate 39 and individual shaft drives to the rear ends of the robot arms 41 enables the robot arms 41 to be extended and retracted toward and away from the plate assembly 39, and enables the plate 39 to be rotated for rotatably positioning the robot arms 41 from location to location, such as from the supply station or port 29 to the reactor 27, or the like.

A pick up wand assembly 43 is operatively mounted to the front end portion of the robot arms 41 for actually picking up or lifting the wafers 81 for transport purposes.

The laminated flow envelope, enclosure or housing 23 includes a floor or bottom portion 45, a top surface 47, a first longitudinal side 49, a second longitudinal side 51, a first end side 53, a second end side 55, and a rear end side 57. The rotatable plate assembly 39, together with the articulated robot arms 41, operatively mounted thereto, and the wand assembly 43 at the opposite end of the robot arms 41 are all housed within the hollow interior 25 of the envelope 23. The rotatable plate assembly 39 is mounted in a recess in the floor 45 and driven by a drive assembly which is vacuum sealed on the opposite side of the floor 45, as hereinafter described. The hollow interior 25 is adapted to provide a controlled clean atmosphere and the atmosphere is preferably one of hydrogen, nitrogen or argon.

Figure 2 illustrates the robot arms 41 in various positions of extension and retraction from the rotatable drive plate assembly 39. In a first arm position, the robot arms 41 are designated by the reference numeral 65 and the pick up wand by reference number 67. In this position, the wand 67 is at its closest position to the circular drive plate assembly 39, and this is referred to as the home position, since it is only in this position that the plate assembly 39 rotates to rotatably position the wand 67 from location to location, such as between the entrance slot 35 of the hollow interior 59 of port 29 and entrance slot 83 to the hollow interior 63 of the reactor 27. Reference numeral 69 illustrates the arms 41 in a secondary position of extension or retraction and shows the position that the wand 71 would occupy for the leg position or robot arm position 69. A third robot arm position is indicated by reference numeral 73 which positions the wand assembly 75 just inside of the access gate or slot 83 to the reactor 27. Lastly, robot arm position 77 shows the pair of robot arms 41 fully extended to position the wand 79 within the hollow interior 63 of the reactor 27 and over the susceptor for delivering the wafer 81 thereto. The reactor 27 is shown as having a substantially hollow interior 63 and the wafer pickup wand 79 is shown as holding a semiconductor wafer 81.

The Figures 3A-3P illustrate the various positions of the robot arm assembly 41 with respect to the wafer pickup assembly 43 and the rotating plate assembly 39. In each of these figures, a portion of the chamber or envelope 23 will be shown with at least one of the stations or ports 29, 31 or the reactor 27. Directional arrows are provided to show either the direction of extension, the direction of retraction, or the direction of rotation during any one step, as represented by the individual figures. Common reference numerals designate common parts as conventionally known in the art.

In Figure 3A, the robot arms 41 are shown in their home position with the wand assembly 43 facing the supply port 29 containing at least one wafer 81 to be picked up. In Figure 3B, the robot arms 41 have begun to extend away from the plate 39 and toward the wafer 81 within the supply port 29. The directional arrow 85 shows the linear direction of movement during the wafer pickup operation. Figure 3C shows the robot arms 41 in their fully extended position with the pickup assembly 43 positioned through the slot 35 and into the supply port 29 for picking up the wafer 81 from a cassette on an elevator housed therein. Figure 3D shows the robot arms 41 in an intermediate position of retraction, as indicated by the directional arrow 87, after it has picked up the wafer 81 and is returning toward the home position of Figure 3E. In Figure 3E, the robot arms 41 are again in the home position and ready for the rotational movement indicated by the rotational direction arrow 89 of Figure 3F. In this position, the robot arms 41 are in the home position as the plate 39 is rotated counterclockwise from the port 29 toward the reactor 27.

In Figure 3G, the robot arms 41 are still in the home position but eh wand assembly 43 now faces the access slot or gate 83 of the reactor 27. In Figure 3H, the robot arms 41 are again shown in an intermediate position while moving the wafer 81 held by the wand assembly 43 toward the reactor 27, as indicated by the directional arrow 91 showing he linear direction of movement from this position. Figure 31 shows the robot arms 41 in a fully extended position such that the wand assembly 43 can position or deposit the wafer 81 onto the susceptor within the reaction chamber 27. Figure 3J shows the robot arms 41 at an intermediate position of retraction, as indicated by the directional arrow 93, and Figure 3K shows the robot arms returned to their home position.

In Figure 3L, the plate 39 again rotates counterclockwise, as per directional arrow 92, to rotationally position the pickup wand assembly 43 and the processed wafer 81, removed from the reactor 27 toward the access slot 37 of the storage port 31. In Figure 3M, the robot arms 41 are in the home position with the wafer pickup assembly 43 facing the slot 37 of storage port 31. In Figure 3N, the arms are shown in an intermediate position of extension as they move toward the slot 37 of port 31, as indicated by directional arrow 94. In Figure 30, the robot arms 41 are fully extended into the port 31 to deposit the wafer 81 on the tracts of a cassette located therein. In Figure 3P, the arms are shown in an intermediate retracted position as they once again return to the home position of Figure 3M, as per directional arrow 96.

Figure 4 is used to illustrate the drive assembly 101 used for driving the extension and retraction movement of the robot arms 41 and the rotation of the plate assembly 39. The rotatable plate 131 is a generally flat, cylindrical plate which is operatively disposed within a circular or cylindrical recess (not shown) located in the floor 45 of the envelope 23. A pair of screw members (not shown) pass through the screw apertures 140, 142 and secure the plate 31 to the drive mechanisms therebelow while a pair of shaft portions 133 and 135 extend vertically above the plane of the cylindrical member 131 and at right angles thereto.

The first shaft extension 133 is adapted to engage a hollow aperture 144 in the rear end connector 145 of the lower robot arm segment 139 while the upper end portion of the second shaft extension 135 engages the hollow aperture 146 of the end connector 147 at the rear end portion of the second lower robot arms segment 141. Each of the lower robot arm portions or segments 139 and 141 are shown as being generally elongated members having a generally hollow gas flow conduit 143 through the hollow interior thereof.

The Drive assembly 101 includes a shaft drive motor 103 which is a conventional DC, digital, micro-stepping motor such as that manufactured as Model No. M062-FC03E by Superior Electric Co. of Bristol, CT, while the robot arm drive motor 105 is a digital DC micro-stepping motor of the type conventionally known as Model No. M092-FC08E, also manufactured by the Superior Electric Co. of Bristol, CT. The digital stepping motor 105, which is used for the extension and retraction of the robot arms 41, is shown as including a rotatable motor shaft 109 and a drive pulley 111 attached to the shaft 109 on one side of the motor 105. A pulley drive member on belt 113 is operatively disposed with one end about the groove of the drive pulley 111 and the opposite end about the groove of a driven pulley or timing pulley 115. The pulley 115 has a top central collar 117 extending vertically upwardly from the top surface thereof and a hollow channel 119 passing centrally through the collar 117 and pulley 115. The drive shaft 121 of the DC stepping motor 103 extends vertically upwardly therefrom and passes clearly through the internally threaded interior 124 of a collar 123 disposed on the upper surface of the housing of the DC stepping motor 103; the internally threaded interior 126 of a nut fastener 128; and the hollow interior channel 119 of the driven pulley 115 and collar 117, and then into the hollow interior of a vertically downwardly extending tubular stem 120 having an externally threaded end portion 122 to enter the ferrofluidic drive housing or compartment 125.

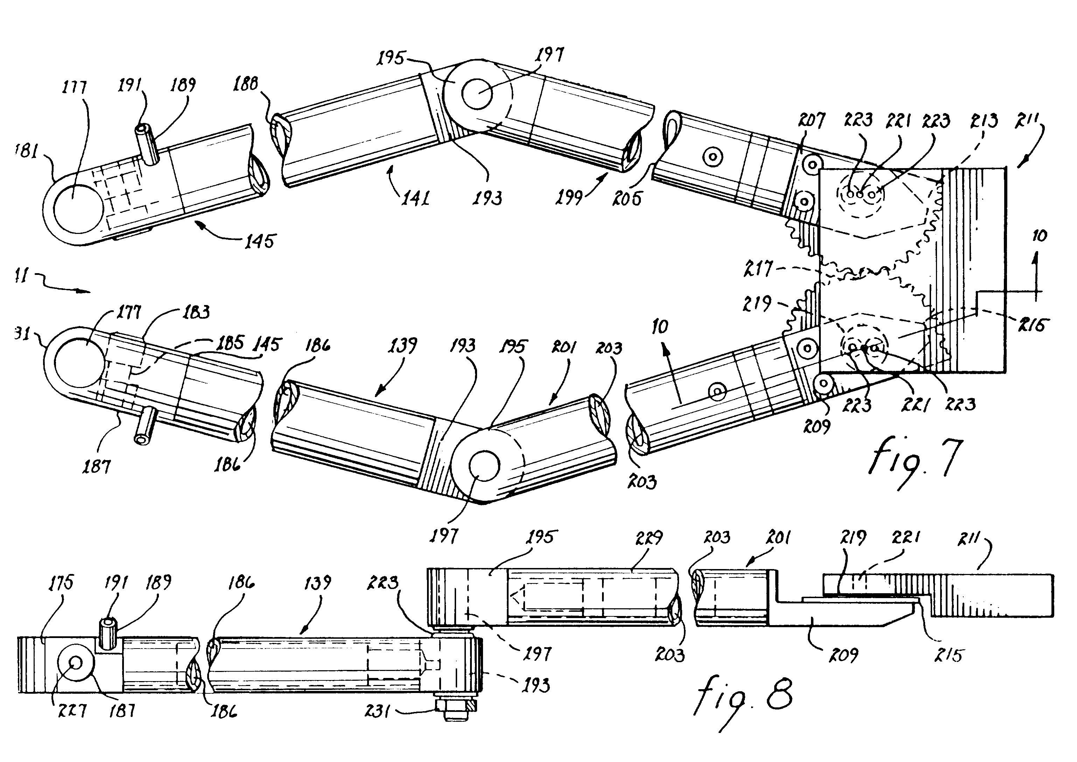

The ferrofluidic drive housing 125 of FIG. 4 will be more extensively discussed with reference to FIG. 5, hereinafter. The output shaft of the ferrofluidic drive housing 125 is used to drive the gear mechanisms of FIG. 6, as hereinafter described, and the gear compartment or housing 127 is coupled through a vacuum seal to the hollow interior 25 of the envelope 23 housing the circular plate assembly 39. The robot arms 41, via the shaft extensions 133 and 135, are driven for extension and retraction motion via the operation of the gears of FIG. 6 and the ferrofluidic drive shaft 121.

The rotation of the circular plate 131 of the plate assembly 39 will now be described. The externally-threaded end portion 122 of the elongated, vertically downwardly extending tubular stem 120 is inserted through the hollow interior channel 119 of collar 117 and the driven pulley 115, through the internally-threaded interior 126 of the nut 128, and is then threaded or screwed into the internally threaded portion 124 of the collar 123. Nut 128 can be used as an adjustment or lock nut. Once the lower end portion 122 of stem 120 is screwed into the collar 123, the driven pulley 115 is securely clamped to the tubular stem 120 and may be pinned thereto as through pin aperture 118 of the pulley collar 117 and a corresponding aperture (not shown) in the hollow stem 120. As the digital DC stepping motor 105 drives the pulley 115, the tubular stem 120 which is fixedly secured to the bottom center of the ferrofluidic housing 125 about an aperture therein, rotates the entire gear housing 127 about bearings 130 in the center aperture of the annular mounting plate 132.

FIG. 5 illustrates the ferrofluidic drive of the housing 125 of FIG. 4. In FIG. 5, the ferrofluidic base plate member 390 is shown as being attached to a metal bellows assembly 393 over which is mounted an annular motor mounting plate 132. Plate 132 includes an annular ring portion 395 an aperture 400, and a pair of elongated members 396. A motor-mounting plate 399 is disposed on the pair of elongated members 396 extending from the motor mount ring 395. A hollow tubular stem or ferrofluidic drive tube assembly 401 includes the downwardly distending hollow tubular stem 120 of FIG. 4 having an annular flange head portion 405 and a threaded end portion 122 is provided such that the intermediate connector 397 passes inside of the thread end portion of the stem 120, and the base of the ferrofluidic drive assembly 401 is operatively disposed within the hollow central drive channel 388 of the ferrofluidic drive member 390. The hollow stem 120 passes a ferrofluidic drive shaft 172 through the top surface portion of the collar or flange 405, and then through a ferrofluidic collar 409 to a pinion gear 167 and its shaft 171 of the gear housing 127. The shaft 172, tube assembly 401, and outer collar 409 comprise the ferrofluidic feed-through mechanism 407 which conveys the extension and retraction drive motion to the arm assembly 41 of FIG. 4, via the gearing mechanism of FIG. 6, as hereinafter described.

The ferrofluidic drive is a commercially available, conventional unit, well-known in the art, and is adapted herein so as to enable both the extension and retraction movement of the arms and the rotational movement of the plate assembly 39 to be done via a single concentric ferrofluidic drive shaft apparatus. The connecting rod 397 passes through the hollow central aperture portion 400 of the motor mount 132 and the central channel 384 of the bellows 393 to engage the central circular channel 388 in the center of the ferrofluidic drive member 390. The channel 388 is surrounded by an annular ring or a collar 386 of the ferrofluidic media which is housed within a larger hollow channel 384. A motor-mounting plate 399 is disposed on a pair of elongated members 396 on one end of the motor mount 395.

A ferrofluidic drive tube 401 which includes a shaft portion 403, a head portion 405 and a threaded end portion 404 is provided such that the connector 397 connects inside of the threaded end portion of the shaft 403, and the base of the shaft 401 is operatively disposed within the hollow central drive channel of the ferrofluidic member 390. The ferrofluidic drive tube 401 passes a ferrofluidic drive shaft 171 through the top surface portion of the collar or flange 405, and this is surrounded by a threaded end portion 411 and an outer collar 409.

FIG. 6 illustrates the gear assembly within the gear box housing 127 of FIG. 4. In FIG. 6, the gear box assembly includes an outer cylindrical wall 151 mounted onto the annular plate 132. The plate 132 is attached by means of bolt members 157 to the top portion of the ferrofluidic drive mechanism 125, as known in the art. The hollow interior 153 of the cylindrical portion 151 receives the thin ferrofluidic drive shaft 171 from the ferrofluidic drive 125 of FIG. 5, and drives a small pinion drive gear 167. The outer peripheral toothed portion of the pinion gear 167 is used to operatively engage or mesh with the teeth on the outer periphery of the large gear 165 which is commonly coupled via shaft 135 to one arm drive gear 163. The outer peripheral gear teeth of drive gear 163 mesh with the outer peripheral teeth of a driven gear 161 connected to shaft 133 so that the shafts 133 and 135 each have an upper extending end portion which extends through the upper surface of the cylindrical plate 131, into the envelope 23, and which operatively engages the rear and portion of a corresponding one of the lower arm members 139 and 141, as shown in FIG. 4. In this manner, the extension and retraction of the arms are accomplished by the respective rotation of the shafts 133 and 135, and hence via the rotation of the gears 161 and 163, respectively. All are driven via the gear 165, which in turn, is driven by the rotation of the ferrofluidic drive shaft 171, via the small pinion gear 167.

FIG. 7 shows the robot arm assembly 41 of FIG. 1 in greater detail. In FIG. 7, the rear end portion 145 of each of the pair of robot arms 41 includes an aperture-forming member 181 and a central shaft-receiving aperture 147 for engaging the extending shaft portions 133 and 135 of FIG. 4, a previously described. Each of the rear end portions 145 includes a head portion 183 having an elongated, externally-threaded stem portion 185 for engaging a hollow, internally-threaded retainer clamp drum 187 for tightening or loosening the grip of the member 181 about the shaft portion 133 or 135 extending through the apertures 147. Furthermore, each of the rear end portions 145 of the lower robot arm segments 139 and 141 includes a gas inlet comprising an elongated cylindrical stem 189 and a hollow interior channel communicating with the hollow interior 185 of the arm segments 139, 141. The inlet channel 191 is connected to a source of gas such as Hydrogen or Nitrogen.

The intermediate portion of the lower arm portions or segments 139 and 141 each includes a generally cylindrical walls 187 and each has a hollow interior 185 or at least a hollow interior gas-conducting passage within the hollow interior thereof. An arm mid-connector 193 includes an elbow portion 197 for engaging the opposing mid-connector 195 of the upper arm assemblies 199 and 201, respectively. Each of the upper arm portions or segments 199 and 201 have a substantially hollow interior portion 203 and a cylindrical wall portion 205. At each of the front end portions of the upper arm segments 199 and 201 is carried a left arm end plate 207 and a right arm end plate 209. Each of the end plates 207, 209 are connected to a Bernoulli mounting plate 211 such that a left hand drive gear segment 213 is operatively coupled to the left arm end plate 207 while a right hand gear segment 215 is operatively coupled to a right arm end plate 209. The outer peripheral teeth of the gear segments 213 and 215 merge or mesh at 217, and a retainer bushing 219 is shown as housing a shaft portion having a hollow central interior gas passage 221 and a pair of outer connector apertures 223.

FIG. 8 shows a side view of one of the pair of robot arms 41 of FIG. 7. In FIG. 8, the rear end portion 145 is shown as including the drum clamp 187 having a threaded internal aperture 227 extending therethrough. The rear end portions 145 also include a gas flow inlet which is shown as a hollow cylindrical stem portion 189 having a hollow gas flow inlet channel 191 for communicating an external source of gas to the internal gas-conducting passage within the hollow interior 185 of the lower arm segment 139. The front end portion of the lower arm segment 139 is connected via mid-connector 193 and the central shaft portion 197 to the upper shaft mid-connector 195, and the assembly is joined by the shaft 197 via bearings 223 and secured therein by a nut 231.

An intermediate portion of the hollow upper robot arm segment 201 is shown as having a first arm filter 229 operatively disposed within the hollow gas conducting passage 203 therein for filtering particles from the flow of gas passing therethrough. The gas passing through the hollow interior 203 of the front end portion 201 is then conducted by the right arm end plate 209 and then upwardly through a bearing 219 for positioning the gear segment 215 thereon, and the hollow gas passage 221 at the central portion of the bearing member 219 conducts the gas to the Bernoulli mount assembly 211.

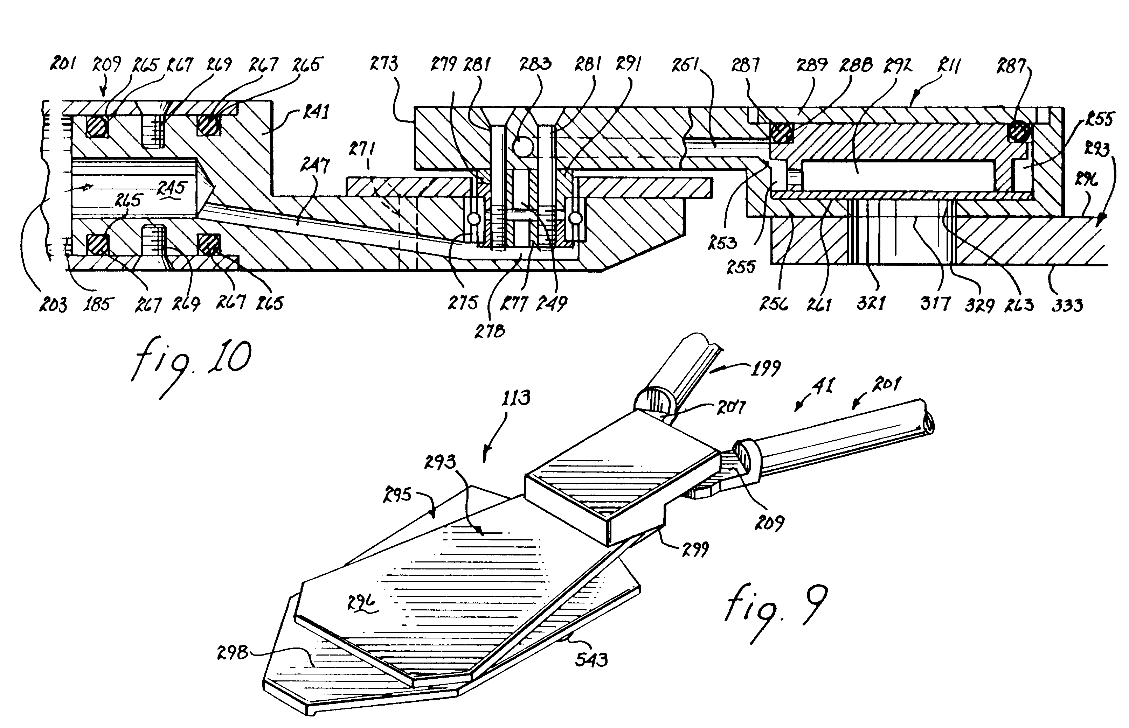

FIG. 9 illustrates the front end portion of the robot arms 41, the Bernoulli mount 211, and the pick-up wand assembly 43 of the present invention. In FIG. 9, the upper arm segments 199 and 201 are shown as being operatively coupled to a lower surface or the Bernoulli mount 211 via the arm end plates 207 and 209, respectively. The wand assembly 43 is shown as being connected to the under surface of the Bernoulli mount 211 by a wand retainer plate 299. The wand assembly includes a first or top gas distribution plate 293 and a second or lower gas outlet plate or pick-up plate 295 which may be referred to herein as the pick-up head or head unit. Each of the plates 293 and 295 is substantially flat or planar and is adapted to have one surface mounted flush against a surface of the other. The top gas distribution plate 293 is shown as having a flat or planar upper surface 296 while the lower Bernoulli pick-up plate or gas outlet plate 295 is shown as having a flat or planar top or upper surface 298. In the preferred embodiment of the present invention, the plates 293 and 295 are made3 of fused quartz which are then acid-etched, for example, with hydrofluoric acid to greatly reduce their tendency to produce or attract particles which might contaminate or damage the wafers. One of the pair of stops or feet are disposed depending downwardly from the bottom surface of the rear of the pick-up plate 295 for use as hereinafter described.

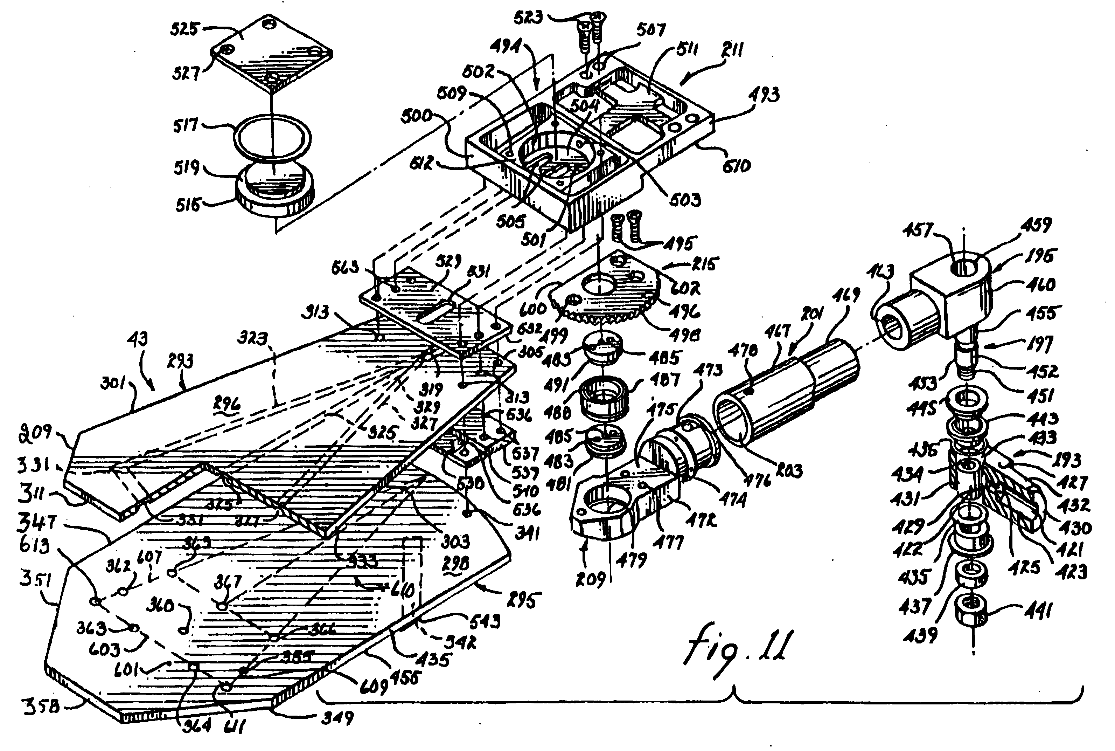

FIG. 10 shows a sectional side view of the forward or front end portion 201 of one of the pair of robot arms 41 including the end attachment plate 209; together with the Bernoulli mount 211 of FIG. 9. In FIG. 10, a front or forward end portion of the robot arm segment 201 is shown as including an end plate 209. The cylindrical robot arm walls 203 are shown as including the hollow interior gas -conducting passage 185 which communicates with a smaller diametered cylindrical gas inlet passage 245 in the front end portion of the end plate 209. The plate 209 includes a metal, preferably stainless steel or some similar structural material, body portion 241 secured within the hollow interior walls 203 of the cylindrical arm portion 201. O-ring gaskets 267 are housed in annular slots 265 to prevent the escape of gas therefrom. The front end portions of the arm 201 are physically connected to the end plate 209 the metal body portion 241 of the end plates 209 via screws or fasteners 269.

A relatively narrow, cylindrical, gas-conducting conduit or passage 247 communicates the end of the cylindrical passage 245 with a vertical gas passage 249. The gas passage 249 is surrounded by a lower retainer 277 and an upper retainer 279. A ring collar 291 and bearing 275 surrounds the central vertical aperture 249 and is connected via threaded fasteners 281 to the Bernoulli pick-up mount 211, as hereinafter described. Another fastener 271 is used to secure the gear segment 215 to the body portion 241 of the end plate 209.

The gas flows through the narrow, gas-conducting, slated passage 247 to the horizontal gas collection chamber 278 and then flows vertically upward through the vertical gas passage 249, through an outlet 283, and into the horizontal passage 251 of the Bernoulli mount 211. The Bernoulli mount 211 includes a body portion 273 having a generally cylindrical recess 255 formed in the front end portion thereof. The floor 266 of the cylindrical recess 255 includes the gas outlet aperture 263. The gas outlet aperture 263 communicates with an opening 317 in the top surface 296 of the upper gas distribution plat 293. The gas inlet 317 communicates through the thickness of the plate 293 via channel 329 to a bottom gas outlet 321. The floor 256 of the cylindrical recess or cavity 255 has an annular final filter 261 disposed thereon for filtering particles out of any gas passing therethrough via the inlet 257 and the outlet 263. An annular member 292 is positioned with an annular flange 294 disposed about the outer peripheral edge portion of the filter 261, and upper shoulders of the annular member 292 contain an annular ring groove 288 for housing an O-ring seal 287. The plunger retainer or annular member 293 is compressably held within the recess 255 via a cover member 289 secured within the opening of the recess opening 285 for replacing the filter 261 or the like. The gas flow passage flows horizontally through the rear portion of the Bernoulli amount 211 via passage 251 and then passes downwardly through the short, narrow, slanted input 253 into an outer annular space 255 about the annular leg member 294. The gas then passes through the narrow gas inlet 257 of the annular leg portion 294 and enters into the hollow central cylindrical cavity or gas reservoir 259 from whence it passes vertically downward through the gas outlet 263 to communicate with the top or upper gas distribution plate 293 of the wand assembly 43.

FIG. 11 shows, in greater detail, the front end portion of the robot arm assembly 41, the mounting plate 211, and the pick-up wand assembly 43 of the present invention. The connection between the first, lower, or rear arm segment 139 with the second, forward, or upper arm segment 201 includes the mid-connector 195, and the shaft assembly 197 therebetween.

In more detail, the front or forward end portion of the first arm segment 139 is attached to mid-portion connector 193. Connector 193 includes a cylindrical body portion 430 integral with a rectangular block-like portion 427. A sleeve portion 432 surrounds the cylindrical portion 430, and the cylindrical portion 430 terminates in a gas inlet 421 whereby the gas travels from the gas inlet 421 through a cylindrical central passage 423 to a relatively small circular gas outlet 425 in the forward end of the cylindrical cavity 423. The opening or outlet 425 communicates through a narrow cylindrical passage 421 to a second gas outlet opening 429 which feeds into the hollow interior portion of the shaft assembly 197, as hereinafter described.

The block-like body portion 427 of the mid-connector 193 includes a hollow cylindrical channel 433 for housing a gas inlet sleeve 431 within the hollow interior thereof. The sleeve 431 has a hollow longitudinal channel 434 therethrough. The channel 434 communicates with on outlet 429 of the gas passage 422 through an aperture or opening in the cylindrical wall of the sleeve 431 which is not shown in FIG. 11. The air inlet sleeve 431 is housed within a cylindrical channel 433 of the rectangular body portion 427 of mid-connector 193 via a bottom seal 435, a bottom collar 437, a washer 439, and a nut 441. Each of the members 435, 437, 439 and 431 has a hollow central aperture for receiving at least the threaded end portion 451 of the shaft assembly 197 therethrough. The externally-threaded end portion 451 of the shaft assembly 197 is adapted to be threadedly engaged by the internal threads of the nut member 441, as known in the art. Securing the sleeve 431 within the channel 433, from above an upper washer 435, an upper collar 443, and an upper washer 445 are provided. The seal 435, collar 443, and washer 445 each has a hollow central aperture for receiving the shaft assembly 197 therethrough.

The shaft assembly 197 includes a shaft 452 having an externally-threaded lower end portion 451, an outer sleeve clamp 453 and an inner sleeve clamp 455 secured to the bottom of the body portion 460 of the mid-connector 195. The mid-connector 195 has a vertical cylindrical channel 459 extending therethrough and a top opening or aperture 457 thereabove. This portion receives at least a portion of the top of the shaft assembly 197 such that the arm segments 139 and 201 are articulated or rendered pivotable about the shaft 452. The mid-connector 195 also includes an integral cylinder portion 464 surrounded by a sleeve 463 and terminating in a hollow interior or channel 466. The channel 466 connects to the mid-portion of the robot arm segment 201 so as to pass the gas flow from the outlet of the cylindrical gas channel 466 to the continuous hollow gas passage or conduit 203 within the hollow interior of the arm segment 201. The hollow interior 203 of the arm segment 201 includes the inner sleeve 469 and outer sleeve 467.

The cylindrical plug portion 473 of the end plate 209 is adapted to be operatively received within the hollow interior 203 of the sleeve 467 for connection purposes through the drum clamp assembly previously described via apertures 476 and 478, respectively. The end plate 209 also includes a partial cylindrical end portion 474 which is sized to be secured to the front end portion of the plug member 473, and the cylindrical end portion 474 carries the generally planar body 474 having a flat upper surface 475 of the end connector 209. The connector 209 contains a plurality of apertures 477 for receiving the threaded members or fasteners 495 therein for securing the apparatus together, as hereinafter described. Additionally, the front end portion of the generally flat body portion 472 includes a generally hollow cylindrical recess 479 therein. The recess 479 is adapted to receive the lower retainer bushing 481 therein.

The retainer bushing 481 includes a pair of outer apertures 483 adapted to receive screw fasteners therethrough and a central hollow channel 485 which forms the vertical gas passage for the assembly. A bearing 487 having a hollow interior 488 is housed over the end portion or annular flange of the lower retainer bushing 481 and the upper portion of the cylindrical interior 488 of the bearing 487 is adapted to receive therein the upper retainer bushing 491. Bushing 491 also includes a central gas passage 485 and a pair of fastener-receiving apertures 483 on either side of the gas passage 485. The top surface portion or wider diameter portion of the upper retainer bushing 491 is adapted to be received within the central aperture 497 of the gear segment 215. The gear segment 215 includes a body portion 496 having a plurality of gear teeth 498 around one of the sides thereof. A flat side 600 and adjacent flat side 602 form the other sides of the gear segment 496. The gear segment is provided with the plurality of apertures 499 for receiving threaded fasteners 495 therethrough.

The mounting block 211 includes a generally rectangular block-like member 494 having a first relatively thin, generally rectangular, rear portion 493 and a second somewhat thicker, generally rectangular, front and portion 500. The rear and portion 498 includes a plurality of apertures 507 for receiving threaded fasteners 523 therethrough for passing through the aperture 497 of the gear segment 496 to engage the outer apertures 483 of the upper and lower bushings 491 and 483, respectively. A gas passage 511, not shown, passes longitudinally through the rectangular rear portion 498 of the housing or mount 211 for receiving the gas by communicating with the central aperture 485 of the upper bushing 491.

The opposite end of the passage 511, passes from the passage 511 into the front rectangular block portion 500 and then through a gas inlet or recess inlet aperture 503 into a generally cylindrical recess or cavity 501 formed in the front portion 500. The cavity or recess 501 has a floor portion 504 which is provided with a plurality of interconnecting gas outlets 505 and which include a cylindrical outer wall portion 502. Threaded apertures 509 in the bottom or floor 504 of the forward rectangular portion 500 receive conventional threaded fasteners, not shown, passing through the apertures 527 of the cover plate 525, as hereinafter described, for closing the top of the cavity of recess 501. The recess gas inlet 503 is disposed a predetermined distance vertically above the recess outlets 505, and a final disk-like filter element 515 is placed on the bottom 504 of the recess or cavity 501 so that any gas passing through the cavity 501 from the inlet 503 to the outlet 505 must pass through the filter element 515 so that even further particles are removed from the gas flow from the articulated robot arms 41. Above the filter 515, a filter plungre member 519 is disposed with the cavity 501, and on top of the plunger 519 is seated an O-ring seal 517 which fits around or about an annular collar portion of the plunger member 519. A top or cover plate 525 is provided with apertures 527 is then placed over the top surface 512 of the front portion 500 to retain the plunger 519 and filter 515 in place within the hollow recess 501 while capping or closing the top surface against the escape of gas therefrom.

The outlets 505 of the recess cavity 501 pass through the bottom surface 510 of the rectangular front portion 500 and communicate with the aperture 531 in a central portion of the mount gasket 529 having a plurality of apertures 533 on the edge portions thereof for receiving conventional fastener means (not shown) for holding the unit together. The bottom surface 532 of the gasket 529 is adapted to be placed over the rear end portion of the top surface 296 of the upper gas distribution plate 293 so that the apertures 533 are aligned with apertures 313 of the gas distribution plate 293, and the gas passage aperture 531 is aligned with the gas inlet aperture 319 which passes through the rear end portion of the upper gas distribution plate 293.

The top plate, upper plate, or gas distribution plate 293 is shown in FIG. 11 as including a generally planar or relatively flat upper or top surface 296 and a relatively flat or planar lower or bottom surface 333. The top surface 296 includes the gas inlet aperture 319 in the rear end portion thereof proximate the rear end 305. A plurality of apertures 313 are included on both edge portions of the rear portion for securing the plate 293 to the bottom surface 510 of the front portion 500 of the mounting block 211 through the apertures 533 of the gasket 529 as previously described.

The portions shown in dotted lines represent the array or pattern of gas distribution channels or grooves formed on the bottom surface or side 333 of the plate 293. The pattern of gas distribution channels or grooves include a first elongated longitudinal side grove 323, a second elongated longitudinal side groove 327 and a lateral groove 331 connecting the diverging front ends of the grooves 323 and 327. The grooves 323, 337 and 331 from an isosceles triangle whose apex terminates in a common gas reservoir or inlet portion 329 communicating with the gas inlet aperture 319 passing through the rear and portion of the plate 293. A central, elongated, longitudinal channel or groove 325 may be provided, bisecting the isosceles triangle along the longitudinal axis of the plate 293 and communicating with the lateral channel or groove 331 at its mid-portion. The gas supplied to the inlet 319, therefore, passes through each of the elongated longitudinal grooves 323, 325, and 327 and is interconnected via the lateral groove 331 forming the base of the isosceles triangle of the geometric pattern of grooves disposed thereon.

The lower or bottom plate, wafer pick-up plate, or gas outlet plate 295 includes a relatively flat or planar top surface 298 and a relatively flat or planar bottom surface 355. Apertures 341 in the rear end portion proximate the rear end 343 are adapted to be aligned with the apertures 537 of the lower wand retainer plate 539, the forward aperture 313 of the gas distribution plate 293, the forward aperture 533 of the gasket 539, and a forward pair of the apertures in the front portion 500 of the mounting block or mount 211. Fastener means passed through these apertures secure the plates 293 and 295 flush against one another in a sandwich-type configuration and for maintaining it in that sealed configuration, with the lower surface 333 of plate 293 over the upper surface 298 of plate 295, as conventionally known in the art.

The top surface 298 of the bottom pick-up plate 295 includes a geometric pattern 601 of gas distribution or gas flow-directing outlets thereon. Each of the outlets is shown on the surface 298 of the lower plate 295 as including a circular opening contained on or within a boundary of the pattern 601. The array or pattern 601, in the embodiment of FIG. 11, can be thought of as including a four-sided geometric figure such as a truncated isosceles triangle. The base of the triangle can be thought of as existing between the imaginary intersections defined at the base end points 611 and 613 and interconnected by the base 603 of the triangle 610. The sides of the triangle can be thought of as terminating at the front and portion 343 of the lower plate 295 such that one pair of gas outlets 361 and 366 define the top truncated portion or and of the truncated triangular pattern 601. Truncated top portion 605 is defined as existing between the gas flow aperture 361 and the gas flow aperture 366 which lie on the sides of the imaginary triangle previously described. The sides of the triangle 410 on the lower plate 295 coincide with the geometric pattern of grooves on the lower surface 333 of the upper gas distribution plate 293 for use as hereinafter described.

The side 607 of the truncated triangular pattern 601 is connected between the imaginary intersection point 613 and gas flow aperture 361 while the opposite side 609 of the truncated triangular pattern 601 is connected between the imaginary intersection point 611 and the gas flow outlet 366. This forms a truncated right isosceles triangle having a base 603, a truncated top 605, and a pair of sides 607, 609.

A pattern of seven gas flow outlets are located or disposed on the border defining the truncated pyramid configuration 601 of FIG. 11. A first gas outlet aperture 361 is formed at the intersection the truncated of triangle side 607 with the truncated top side or end 605, while an opposing or opposite second gas outlet 366 is formed at the opposite end of the truncated top 605. A third gas outlet aperture 362 is disposed on the side 607 of the pattern 601 closer to the imaginary intersection 613 than to the aperture 361, and a corresponding fourth gas outlet aperture 355 is disposed on the side 609 of the pattern 601 closer to the imaginary intersection point 611 than to the aperture 366. A fifth aperture or outlet 363 is formed on the base 603 between the imaginary end point 613 and the longitudinal axis of the wand assembly 43. Equally spaced on the opposite side of the longitudinal axis is a sixth gas outlet aperture 364 located approximately in the middle between the longitudinal axis and the opposite imaginary end point 611. Lastly, the seven gas flow outlet 367 is disposed on the longitudinal axis at the midpoint of the truncated top 605.

Each of the gas flow apertures 361,362, 363, 364, 365, 366, and 367 communicates with a corresponding gas flow outlet on the lower or bottom surface 355 of the pick-up plate 295, and each is interconnected thereto through a slanted or tapered intermediate channel portion. The tapered channel connecting the laterally displaced upper and lower outlets enables the seven gas flow outlets located on the periphery or boundary of the truncated pyramid configuration or pattern 601 to direct the gas flow substantially radially outward from a central portion of the configuration 601 so that the gas flow is directed substantially radially outward across the top surface of the wafer 81 to be picked up or lifted so as to provide the necessary conditions to effect application of the Bernoulli Principle. The gas flow across the top surface of the wafer creates or establishes an area, volume, or zone of relatively low pressure between the bottom surface 355 of the pick-up plate 295 and the top surface of the wafer 81 with respect to the pressure existing at the bottom of the wafer. This pressure difference serves to lift or pick-up the wafer without any physical contact whatsoever between the wand assembly 43 and the top or bottom surface of the wafer 81.

Furthermore, this pattern provides a continuous outwardly sweeping flow of gas across the top surface of the wafer which greatly reduces the number of particles or contaminants which can collect thereon. Some very slight, soft contact can occur between two spaced apart areas on the outer peripheral rim of the wafer 81 and a pair of downwardly distending locator or stop members 543. The locators 543 are disposed on the rear end portion of the lower or bottom surface 355 of the gas outlet plate 295 adjacent sides 345 and 347 thereof. An important function of the array of gas outlets is that the gas flow is biased to draw the wafer slowly rearwardly under the pick-up plate 295 until two short segments on the wafer's outer peripheral edge make soft contact with the front sides 542 of the stop members 543. This soft gentle contact is now between the top surface of the wafer and the bottom surface of the pick-up plate 295, but only with two small areas on the outer peripheral circumference of the wafer and the soft contact locator or stop members 543. The above-mentioned rearward horizontal bias results from the orientation of the gas outlets in the pattern or array of outlets in which only two of the seven outlets are radially outwardly directed in a forward direction whereas five of the array of seven outlets are radially outwardly directed in a rearward direction. This creates a horizontal component of force tending to urge the picked-up wafer rearwardly until it makes soft contact with the stops 543. Other advantages of these features will be discussed hereinafter with regard to the operation of the apparatus of the present invention and the pattern of gas flow-directing outlets and their orientation with respect to the bottom surface 355 of the pick-up plate 295.

It is obvious that when the bottom surface 333 of the upper gas distribution plate 293 is placed over and flushed against the top surface 298 of the gas outlet plate 295, that all of the apertures or outlets 361, 362, 363, 364, 365, 366, and 367 are operatively disposed directly beneath the pattern of triangular grooves 323, 325, 327, and 331 formed on the bottom surface 333 of the upper gas distribution plate 393 for supplying, conducting, or distributing gas thereto.

Additionally, a central outlet 368, which is supplied with gas from the central longitudinal groove 325 on the bottom surface 333 of the supper gas distribution plate 293 is located approximately in the center of the geometric pattern 601 along the longitudinal axis of the plate 295 and is, contrary to the other gas outlet apertures, disposed at a 90 angle straight through the lower pick-up plate 295. The flow of gas from this outlet serves to aid in substantially reducing or eliminating turbulence, rapid vertical oscillations or wafer dribbling, and in substantially totally eliminating the pick-up particles which would otherwise result from the "vacuuming effect", as hereinafter explained.

The lower retainer plate 539 is disposed beneath the bottom surface 355 of plate 295 and the apertures 537 are aligned with the apertures 341 of plate 295, apertures 537 are aligned with the apertures 341 of plate 295, apertures 313 of plate 293, apertures 533 of the upper retainer plate 529 and apertures in lower surface of the front 500 of mounting plate 211. Conventional fasteners then secure the plates 293, 295 securely together in a sandwich-like manner. A teflon tape 539 with corresponding tape aperture 538 insures a firm contact of the upper surface 536 to the lower surface 355. The fasteners, not shown, pass upwardly through the assembly and screw into the bottom of mount 211. The removal of a few screws enables one pick-up wand adapted or dimensioned to use with a first predetermined diameter of wafer to be easily selectively removed and interchanged with another wand adapted to or dimensioned for use with another predetermined diameter of wafer.

FIG. 12 shows the bottom or lower surface 333 of the top gas distribution plate 293 of FIG. 11. In FIG. 12, it is seen that the upper gas inlet 319 enters into a reservoir or cavity 317, formed in the bottom surface 333 of the upper gas distribution plate 293. The reservoir portion 317 communicates via outlet 321 with the commonly connected ends 329 of the pattern of grooves, as hereinafter described. The pattern of grooves includes the first and second elongated longitudinal side grooves 323 and 327 and the transverse or lateral groove 331 which together form an isosceles triangle having a base corresponding to the lateral channel 331, a pair of sides corresponding to the longitudinal grooves 323 and 327, and an apex meeting at the gas inlet 321. The commonly connected or overlapping end portions form a reservoir at 329 and the gas from the outlet 321 passes into the common collection point 329, from whence it is fed into and along each of the grooves of the interconnected, isosceles triangular pattern. A central elongated longitudinal groove 325 is disposed along the longitudinal axis of the upper gas distribution plate 293 and has one end terminating in the common end portion 329 and its opposite end connected at a mid-portion of the lateral groove 331 such that it dissects the base of the isosceles triangular pattern. The gas passes through the upper distribution plate 293 via the gas inlet 319 and is then fed into each of the interconnected grooves 323, 325, 327, 331 for the purpose of supplying or feeding the gas to the gas flow-directing outlets of the lower plate 295, as hereinafter described with reference to FIG. 15.

FIG. 13 shows a sectional end view of the bottom surface 333 of the upper gas distribution plate 293 of FIG. 12. FIG. 13 shows the upper plate 293 as including a single, integral, substantially flat member 294 comprised of fused quartz and having a relatively planar top surface 296 and a relatively planar bottom surface 333. The ends 301 and 303 represent the sides between which the section is taken, and since the section is taken through each of the elongated, longitudinal grooves 323, 325, and 327, the grooves will be seen as generally rectangular channels cut or otherwise formed into the lower surface 333 of the plate 393.

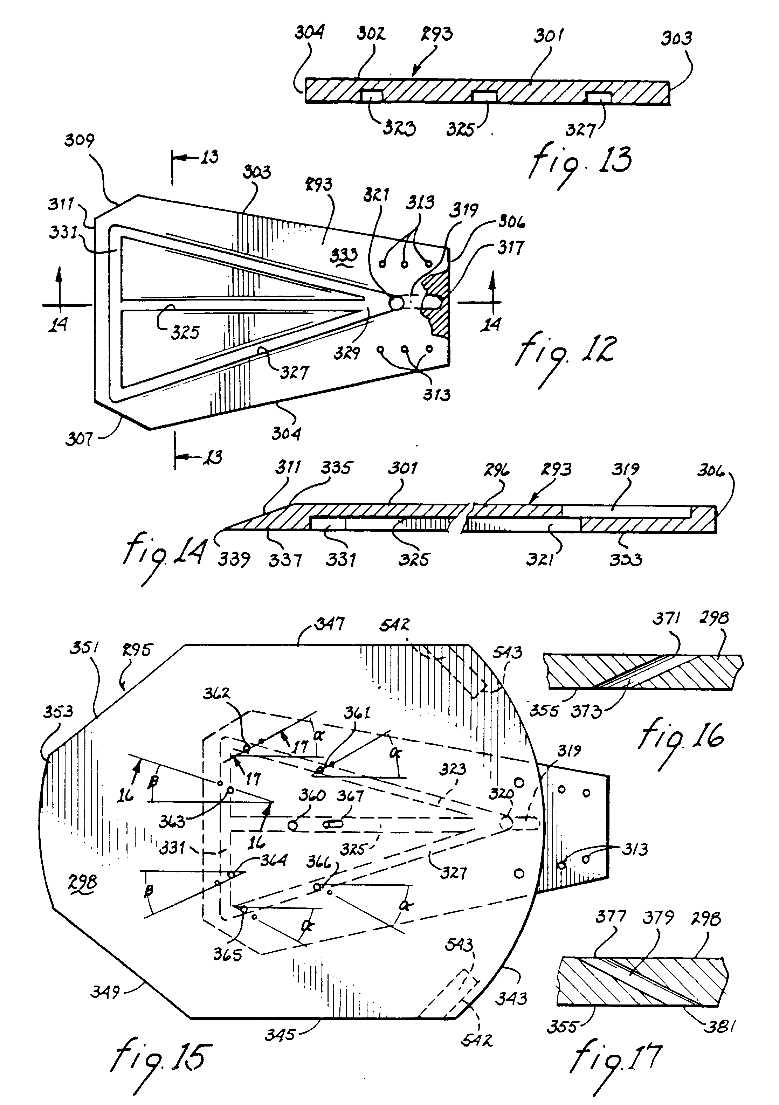

FIG. 14 shows a longitudinal cross section of the upper gas distribution plate 293 of FIG. 12 as including the single integral body portion 294. The rear end portion 305 is disposed along the longitudinal axis which terminates at the font end portion 311. The front end portion 311 is shown as including a relatively planar front edge portion 337 of the flat bottom surface 333, a tapered top surface 335, and a pointed tip or end portion 339. The gas distribution inlet 319 can be seen as being operatively disposed in the top surface 296 of the upper gas distribution plate 293 proximate the rear end 305. The outlet 321 communicates the gas distribution outlet 319 with the commonly connected portion 329 of the paths or grooves via outlet 321, as previously described. The present section is taken through the central elongated longitudinal groove 325 which passes through or along with longitudinal axis of the upper gas distribution plate 293. At the end of the central longitudinal groove 325, the intersection with the lateral groove 331 is shown.

FIG. 15 shows a top view of the pick-up plate 295 of the present invention. The lower pick-up plate 295 is shown as including a top surface 298, a relatively curved rear end portion 343, a pair of relatively straight front end portions 349 and 351, and a curved or straight central front edge portion 353. The top surface 298 of the pick-up plate 295 is relatively flat or planar and includes only a plurality of apertures formed therein. As previously described with reference to FIG. 11, the apertures are distributed within the boundary of a geometric pattern represented by a truncated pyramid 601. The gas inlets located on or within the boundary of the geometric configuration or pattern 601 include the outlets 361, 362, 363, 364, 365, 366, and 367. These seven inlets define the basis pattern 601 while the common relief outlet 368 is disposed in a central portion of the pattern for use as previously described. The top surface 298 or the pick-up plate 295 better illustrates the slope, taper, or slant of the gas outlets on the boundary of the pattern and it will be seen that the flow is generally radially outward from the approximate center of the geometric pattern so as to provide a continuous outwardly sweeping action for keeping particles off of the top surface of the wafer while simultaneously providing the area of decreased pressure for enabling the Bernoulli Principle to be used for lifting or picking-up the wafer without physical contact between the surfaces thereof and still further, since five of the seven outlets are directed horizontally, the wafer is slowly urged horizontally toward rearward until it abuts the stop or locator members 543.

FIGS. 16 and 17 illustrate the slanted channels described with respect to FIG. 15. The apertures are shown as having a circular inlet 371 on the top or upper surface 298 of the pick-up plate 295, a circular outlet 375 on the bottom surface 355 of the pick-up plate 295 and a sloped interconnecting channel 273 operatively connecting the upper circular inlet 371 and the lower circular outlet 275. Similarly, the oppositely sloped gas outlets of FIG. 17 can be considered as having a circular aperture 377 in the top surface 298 of the pick-up plate 295, a lower circular outlet 381 in the lower surface 355 of the lower pick-up plate 295 and a sloped, slanted, or tapered interconnecting channel 379 communicating the upper circular aperture 377 with the lower circular gas outlet aperture 381. The particular slope of the channel will determine the direction of gas flow from the bottom 355 of the plate 295 and hence can provide the desired substantially radially outward flow for maximizing the efficiency of the pick-up operation of the present invention while simultaneously minimizing particulate contamination.

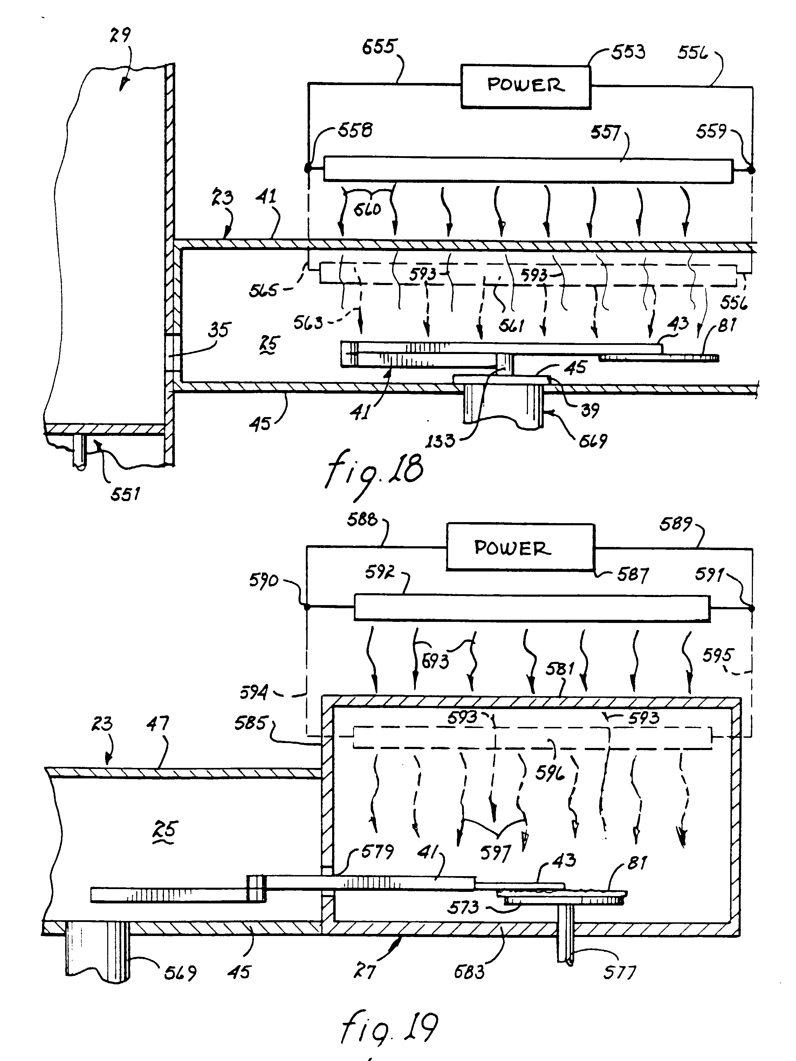

FIGS. 18 and 19 illustrate yet another embodiment of the water handling system of FIG. 1 and add additional means for reducing particular contaminants in the system. In FIG. 18, the envelope or enclosure 23 is shown as having a top panel 47 and a bottom panel 45 with a hollow interior 25 disposed therebetween. As previously described, a portion of the drive assembly, such as the gear housing 569 is coupled through a vacuum seal to the rotatable plate assembly 39 which serves to drive the pair of articulated robot arms 41 having the pick-up wand assembly 43 mounted at the front end portion thereof for picking up and carrying semiconductor wafers 81. The rear end portion of the articulated robot arms 41 are shown as being operatively coupled to the shaft portion 133 extending through the floor 45 and the plate 39. A supply station, purge box, or supply port 29 is shown as including an elevator 551 for carrying a cassette holding a plurality of wafers (not shown) in a horizontal position, as known in the art. The elevator 551 moves vertically in a stepwise linear manner to accurately position the wafer before the access slot 35 through which the robot arms pass to pick-up a wafer 81 contained in the cassettes for delivery to the reactor 27, as previously described.

In the embodiment of FIG. 18, a source 557 of ultraviolet (UV) infrared rays 560 is provided. The source 557 may be any conventional tube or source of ultraviolet rays chosen to radiate in the desired spectral range such that the UV rays pass readily through a top quartz plate 47 of the envelope 23. The top plate 47 is preferably made of fused quartz which is transparent to UV radiation at the radiating wavelength. The source 557 is provided on the exterior of the top plate or cover 47, and the UV rays 560 pass through the quartz wall r7 and bombard the central area on the interior 25 of the envelope 23 so as to continually irradiate the robot arms 41, wafer pick-up wand 43, and the top surface of the wafer 81 carried thereby whenever the arms 41 are in the home position. Since the plates of the pick-up wand are also made of quartz, the UV rays pass readily therethrough to bombard the top surface of the transported wafer and the area thereabove. The purpose of the bombardment with ultraviolet rays 560 is to neutralize the charge of contaminant particles within the hollow interior 25 of the chamber 23. By removing the charge, the particles are loss likely to interact with, stick to, be attracted to, or accumulate on the top surface of the wafer 81. The bombardment with ultraviolet rays further reduces particles contamination and further improves cleanliness of the wafer handling system of the present invention.

The UV source or tube 557 is shown as having one terminal connected to a node 558 which in turn is connected via lead 555 to one output of a power source 553. The power source 553 is also connected through a lead 556 to a second node 559. Node 559 connects to the opposite end terminal of the tube 557 so that power is supplied to the tube for generating the ultraviolet radiation 560 via the power source 553 as known in the art.

Alternatively, the tube or source 561 can be place within the hollow interior 25 of the envelope 23 adjacent the top plate 47. The ultraviolet radiation or rays 563 again perform the bombardment necessary for neutralizing charged particles which might otherwise contaminate the wafer 81. The tube 561 is powered via lead 565 coupled between one end terminal of the tube 561 and to the input node 558, while node 559 is coupled via lead 557 to the opposite end terminal of the tube 561 for supplying power thereto from the power source 553, as known in the art.

FIG. 19 provides yet another embodiment of the concept FIG. 18. In FIG. 19, the envelope 23 is shown again as including a transparent quartz upper panel 47 or window and lower panel 45. The drive mechanism 569 is again shown as being connected through a vacuum seal from beneath the surface of the bottom panel 45 to the interior rotatable plate assembly 39. The shaft end 133 couples the drive mechanism with the rear end of the articulated robot arms 41 for extending and retracting them. The wand assembly 43 is shown as depositing the wafer 81 onto a rotatable susceptor 573 mounted on pedestal 575 having a rotatable shaft 557. The assembly including the susceptor 573, the pedestal 575 and the shaft 577 may be upwardly and downwardly, vertically positionable and rotatable, as desired. The robot arms 41 are shown as being in the fully extended position and as passing through the gate 579 communicating with the hollow interior 571 of the reaction chamber 27. The top 581 and bottom 583 of the reaction chamber 27 are again made from quartz which is transparent to ultraviolet radiation of a particular wavelength or range of wavelengths.

A source of radiation or tube 592 is operatively mounted or disposed on the exterior of the upper plate 581 and arranged so as to radiate the interior proximate the entrance or between the gate and the susceptor of the reactor 27 with ultraviolet rays or radiation 593 for further neutralizing charged particle contaminants adjacent the access gate 579 and through the input portion of the reaction chamber 27 through which the wafer 81 passes as the robot arms 41 are extended to place the wafer 81 on the susceptor 573. The power source 587 is connected through a first lead 588 and a node 590 to one terminal of the tube 592. The power source 587 is also connected through a lead 589 to a node 591 and then to the opposite terminal of tube 592.

In an alternate embodiment, the UV source or tube 596 is operatively mounted or disposed within the hollow interior 571 of the reactor 27 adjacent the upper wall or plate 581. The tube 596 produces similar UV radiation or rays 597 for bombarding the path of the wafer 81 from the access gate 579 to the susceptor 573 to further serve to eliminate particulate contaminants by neutralizing charged particles to prevent them from accumulating or the wafer surface. The tube 596 has one terminal connected via lead 594 to input node 590, and its opposite terminal connected via lead 595 to input node 591 so that the power is supplied from the power source 587 thereto.

In the preferred embodiment of the present invention, the pair of articulated robot arms 41 are much stronger and more accurately positionable than was heretofore possible in the prior art. The length of the robot arms 41 at their fully extended position is significantly longer than the 18 inches normally possible in the prior art. In fact, lengths of at least 25 inches are routinely possible using the articulated robot arms 41 of the present invention.

In the present invention, the articulated robot arms are manufactured using substantially all stainless steel in their construction. Furthermore, they have a cylindrical or tubular construction and a circular cross section which provides still additional strength over the rectangular arms used in the prior art. Both the upper gas distribution plate 293 and the lower pick up plate 295 of the pick up wand assembly 43 are manufactured from fused quartz which is acid etched and polished with an acid such as hydrofluoric acid. The etching and polishing not only smooths and polishes the grooves and apertures formed in the plates to prevent particles from originating thereon, but also polishes all of the upper and lower surfaces to prevent particles from being attracted to or accumulating on the surfaces, therefore reducing the chance of contaminating or damaging the wafer. The use of quartz for the wafer pick up unit enables the unit to be used to pick up relatively hot substrates. Normal processing in the reaction chamber raises the wafer temperature to approximately 1150°C. The temperature cools down to below 1000°C in about one minute. A very short time later, when the wafer temperature is lowered to 800°C to 900°C, the pick up wand can lift the hot wafer without damage thereto.

The walls of the envelope 23 making up the enclosure of the wafer handling system 21 of the present invention are preferably made of a non contaminating material, such as anodized aluminum or the like, and a window, preferably made of an ultraviolet transparent material, such as fused quartz, is provided therein for observation purposes. Cassette elevators and wafer cassettes can be used for maintaining the wafers in a horizontal position both in the supply port 29 and the storage port 31, as known in the art.

The drive means includes means for driving the robot arms for pick up and delivery of wafers to other stations or the like, as well as a rotational movement between stations or locations within the system. The drive system of the present invention is greatly improved to provide much greater accuracy than was heretofore available in the prior art. Highly accurate digital DC micro-stepping motors are used for driving both the extension, retraction and the rotational positioning of the arms. The interior of the cylindrical arms includes a continuous gas passage therethrough so that gas is supplied from an external source through the robot arms to the gas distribution wand 293, as described herein. The gas used is dependent upon the operation to be effected, and in the epitaxial deposition system described, the gas will be either hydrogen or nitrogen, as desired, depending upon the particular operation then being conducted. Gas can be supplied from any conventional gas container or source having an on/off valve which is either all on or all off.

In the preferred embodiment, the two gas outlets from the valves at the tanks then pass through a toggle so the operator can select either hydrogen or nitrogen, as desired. This construction is known in the prior art and will not be described in detail. The gas is then supplied via conduits to the tubular stems disposed at the rear end portions of the wand assembly as described previously. Furthermore, the drive system of the present invention uses a ferrofluidic drive and is vacuum sealed from the interior of the enclosure.

The reactor 27 may be a reaction chamber designed for epitaxial deposition.

The unique geometric pattern of gas distribution outlets described in the preferred embodiment, represents the optimum now known to the Applicants herein at the time of filing. Various other patters or arrangements have been shown by experiment to work, but these appear optimal at the present time. The main point of the design of the pattern of the outlets is that the outlets substantially radially direct the gas flow outwardly across the surface of the wafer to provide the necessary gas flow to implement the Bernoulli pick up effect, while simultaneously continuously sweeping the top surface of the wafer to prevent contamination by particles or the like. Lastly, the use of the UV radiation bombardment, either inside or outside the wafer handling envelope or the reactor envelope, serves to neutralize charged particles contamination and further reduce particular contamination of the wafers.

The present invention has at least three relatively broad inventive purposes all of which are accomplished simultaneously in the embodiments set forth herein. The first purpose is to provide a pickup and delivery system for use in a high speed, continuous, single wafer processing system which will not damage the wafer. The second purpose is to provide every possible means of reducing or eliminating particulate contaminants and the like so that the actual particle count is reduced to two or three particles per wafer. This is possible when the system is optimally tuned and all of the features of the present invention are used simultaneously. The third purpose is to provide for a "hot" pick up wherein processed wafers can be picked up shortly (within a few minutes) after processing without waiting for an extended cool down period thereby speeding up the process and increasing its efficiency.

The problem of contamination by particles is absolutely critical in the today's semiconductor processing industry. With the trend toward larger and larger wafers, and toward more complex integrated circuits on each wafer, even a single particle settling onto the wrong spot on a complex circuit will render the circuit inoperative or otherwise damaged, resulting in a cost of hundreds or even thousands of dollars for the lost circuit or circuits, thereby greatly reducing the yield of the particular wafer being processed. Any feature of a system which can eliminate or reduce particulate contamination is important.

The greatest sources of contamination in a wafer fabrication area are the people that perform the operations. Human beings are continuous sources of organic matter because of the constantly renewing nature of their bodies. It is possible to neutralize the presence of operators by instituting certain sets of procedures. The first step is to partition off the wafer fabrication area assuming that the normal steps are taken to provide a true clean room environment. This need is greatly reduced if the purge boxes of Assignee's copending patent application are used. Additional procedures can be implemented within the processing system itself to reduce the chance of particle contamination. With most of the wafer handling or transport mechanisms of the prior art, the surfaces of the wafers themselves are often crashed into or at least contacted with the transport mechanism, with the guide slots in the cassettes, and during pick up and deposit at the various work stations. This results in mechanical defects, cracks, chips, and the like. Frequently, unbaked or uncured depositions chip or come off and adhere to the walls, transport mechanisms, or the like so as to form still another source of contamination for future wafers being handled by the system. Even a slight physical shock or chipping will reduce the yield of a wafer and often cause defects in the crystalline structure which are not readily apparent even upon routine inspection.

It is therefore necessary to provide a wafer handling system or wafer transport mechanism which insures that there is absolutely no harmful contact between at least the top surface of the wafer and any portion of the system. Furthermore, the present system goes even further and insures that there is absolutely no physical contact between the pick up wand and the top surface of the wafer itself, which has never been achieved in the prior art systems, but only between the locators or stops distending below the bottom surface of the pick up plate and two small areas on the outer peripheral edge of the wafer. The use of the prior art bottom pick up systems don't necessarily contact the top surface of the wafer although they do the bottom surface, but such bottom pick ups can't be used in the present invention because they cannot place a wafer on a flat continuous susceptor as required herein.

Thus, contactless pick up is made by implementing the Bernoulli Principle for pick up purposes. The pattern of holes or apertures directs the gas flow across the top surface of the wafer to be processed in such a manner so as to significantly reduce the pressure in a zone or volume of space between the bottom surface of the pick up plate and the top surface of the wafer (with respect to the pressure existing below the wafer), and this pressure differential enables the wafer to be lifted or picked up without any type of physical contact between the pick up wand and the top surface of the wafer itself. Therefore, any chance of chipping, breaking, physical damage or the like is substantially eliminated.

Simultaneously, the direction of the gas flow is generally radially outward so that it continually sweeps the top surface of the wafer free of particles and greatly reduces any chance of particle contamination of the wafer surface. This feature has never been utilized in the prior art for reducing contamination either. The pattern of gas outlet holes also optimizes the uniformity of the pick-up gap between the bottom surface of the pick up wand plate and the top surface of the wafer while significantly eliminating or at least reducing turbulence and wafer dribbling. The use of the central pressure relief aperture provides an area of zero pressure differential on a central portion of the top surface of the wafer which (in combination within the outwardly directed flow outlets) substantially totally eliminates the problem of particle contamination due to the "vacuuming effect", while aiding in the reduction of turbulence, wafer dribbling, and the like. When combining the central aperture with the outwardly directed apertures, the particle reduction characteristics greatly exceed any heretofore possible in the prior art.

The use of internal filters within the gas passage in the articulated robot arms for filtering particles out of the gases passing therethrough additionally serves to eliminate particle contamination.

Furthermore, the use of the final filter in the Bernoulli mount for filtering the gas as it exits from the front ends of the robot arms and passes into the gas inlet of the wand assembly still further reduces particles contained in the gas flow. Lastly, the use of ultraviolet radiation within a central portion of the wafer handling chamber and/or within the input portion of the reactor to neutralize charged particles, even through the quartz pick up head, still further serves to reduce the chance of particle contamination and renders the wafer processed by the system of the present invention far superior to the cleaner than anything heretofore possible with resulting increased yields and increased system efficiency.

Briefly, the operation of the wafer handling system of the present invention will be described. The robot arms 41 are normally maintained in the home or fully retracted position with respect to the circular port 39. When it is desired that a wafer be picked up from the bin 29, the plate rotates until the wand assembly 43 faces the access slot 35 of the supply port 29. The arms 41 are continually maintained in the home position during rotation. ONce the rotation stops, the arms 41 are extended so that the wand assembly passes through the access slot and into the cassette for picking up a wafer. The wafer is picked up when the gas flow is turned on only after the arms 41 are fully extended and stopped. The wand assembly is then positioned above the wafer to be lifted, and the gas flow is initiated.

After pick up, the robot arms are then retracted to the home position and held in that position while the plate rotates to position the wand directly in front of the entrance to the reaction chamber 27. The arms are then extended to position the wafer on the susceptor therein; gas flow is stopped; the wafer deposited; and the arms are withdrawn to the home position to await the termination of processing. The arms then extend back into the reactor to pick up the processed wafer while it is still hot; the gas is turned on; the wafer is picked up; and then the arms retract back to the home position. The plate 39 then rotates until the wand assembly with the processed wafer being carried thereby is positioned in front of the access slot to the supply port. The arms are then extended to deposit the wafer within the cassette housed therein; the gas is shut off; and then the robot arms retract to the home position or perhaps are retracted and then rotated until the wand is again facing the storage port 29 to begin the cycle anew.

The gas flow through the articulated robot arms 41 is only begun and terminated when it is in position within the respective compartments. This reduces a continuous flow of gas from the wand which might otherwise stir up particles within the wafer handling envelope. The basic movement of the articulated arms is old in the art and does not form a portion of the present invention per se.

## Claims

1. A wafer handling and transport apparatus (21) for lifting and retaining a wafer (81) having opposed top and bottom surfaces and a wafer perimeter, without physically contacting the top or bottom surfaces of the wafer, and transporting the wafer from a first location to a second location utilizing a source of gas and a pickup wand assembly (43) supported by at least one arm (41), the apparatus characterized by:
the pickup wand assembly having a lower plate (295) with a generally planar lower surface (355);
a gas distribution path (323, 325, 327, 329, 331) within the wand assembly;
at least one first outlet (368) disposed centrally in and oriented essentially normal to the lower surface of the lower plate for receiving gas from the gas source through the gas distribution path and expelling the gas from the lower surface to develop a low pressure environment above the wafer and establish an omni-directional flow of gas across the wafer upon retention of the wafer; and
a plurality of second outlets (375, 381) disposed in the lower surface of the lower plate arranged in a predetermined pattern for receiving gas from the gas source through the gas distribution path and expelling the gas from the lower surface to develop a low pressure environment above the wafer and establish a plurality of streams of gas flow toward the perimeter of the wafer, wherein the plurality of second outlets includes at least one outlet (381) oriented generally toward the arm and at least one outlet (375) oriented generally away from the arm, and the plurality of second outlets is arranged to expel more gas toward the arm than away from the arm to impart a net frictional force on the wafer in the direction of the arm.

2. The apparatus as in Claim 1, wherein the plurality of second outlets includes at least two outlets (381) oriented generally toward the arm and at least one outlet (375) oriented generally away from the arm, and wherein the outlets oriented toward the arm outnumber the outlets oriented away from the arm.

3. The apparatus as in Claims 1 or 2, including at least one locator (543) on the wand assembly (43) extending below the planar lower surface (355) for contacting the perimeter of a lifted wafer (81) and limiting the movement of the wafer in the direction of the arm.

4. The apparatus as in Claim 1, wherein the gas distribution path (323, 325, 327, 329, 331) includes a plurality of interconnecting passageways disposed in the wand assembly (43) for interconnecting each of the first and second outlets (375, 381).

5. The apparatus as in Claim 1, wherein said apparatus includes a valve means for selecting a gas received by the wand assembly (43) from a choice of two gas sources.

6. The apparatus as in Claims 1 or 5, wherein the lower plate (295) has a planar upper surface (298) and the wand assembly (43) further comprises:
an upper plate (293) having a generally planar lower surface (333) juxtaposed over the upper surface of the lower plate;
a gas inlet aperture (319) in the upper plate adapted to receive the outflow of gas from the source of gas, the inlet aperture being in fluid communication with a reservoir groove (329) formed in the lower surface of the upper plate; and
a plurality of gas distribution grooves (323, 325, 327, 329, 331) formed in the lower surface of the upper plate in fluid communication with the reservoir groove and with the first and second outlets (375, 381).

7. The apparatus as in Claim 6, wherein the lower (295) and upper plates (293) are quartz.

8. The apparatus as in Claims 1 or 7, wherein the arm (41) is stainless steel.

9. The apparatus as in Claim 6, wherein the plurality of gas distribution grooves (323, 325, 327, 329, 331) is arranged in a triangular pattern with an apex toward the arm (41) and a central bisecting groove, the triangle being centered over the wafer (81), wherein the second outlets (375, 381) are distributed in the lower plate in communication with the triangular pattern of grooves and the central groove and wherein the first outlet (368) is located in the lower plate in alignment with the central groove.

10. The apparatus as in Claim 6, wherein the lower plate (295) of the wand assembly (43) includes slanted channels (373, 379) connecting the gas distribution grooves (323, 325, 327, 329, 331) with the second outlets (375, 381), the channels being slanted to direct gas flow from the second outlets toward the perimeter of the wafer (81).

11. The apparatus as in Claim 1, wherein the at least one arm (41) is hollow for conveying a flow of gas therethrough, and wherein the pickup wand assembly (43) includes means (207, 209, 211) for receiving a flow of gas from the arm for delivery to the first and second outlets (375, 381).

12. The apparatus as in Claim 11, further including a filter (229) disposed in the hollow arm (41) for intercepting particles in the gas flow through the arm.

13. The apparatus as in Claim 11, wherein the receiving means (207, 209, 211) of the pickup wand assembly (43) includes a filter (261) for intercepting particles in the gas flow through the arm (41).

14. The apparatus as in Claim 1, wherein the at least one arm (41) comprises a pair of articulated robot arms at least one being hollow for conveying a flow of gas therethrough, and the pickup wand assembly (43) includes means (207, 209, 211) for receiving a flow of gas from the at least one hollow robot arm for delivery to the first and second outlets (375, 381).

15. The apparatus as in Claim 14, wherein each of the robot arms (41) includes a first end portion (139, 141) and a second end portion (199, 201) connected at a swiveling joint (193), and wherein the pickup wand assembly (43) is supported by the second end portion of each arm of the pair of robot arms.

16. The apparatus as in Claim 15, including a drive assembly (101) attached to the first end portions (139, 141) of the robot arms (41) having a drive means to impart rotary motion to the first end portions for retracting and extending the pickup wand assembly (43) and for rotating the robot arms to pick up and deliver the wafer (81) from the first location to the second location.

17. The apparatus as in Claim 1, wherein the pickup wand assembly (43) is demountably attached to the arm (41) for selectively replacing one size pickup wand assembly with another to enable handling and transport of different sized wafers (81).

18. The apparatus as in Claim 1, including an enclosure (23) for housing the wand assembly (43) and the arm (41) in fluid communication with the first and second locations between which the wafer (81) may be transported, and a source of UV radiation (557) for irradiating the enclosure to neutralize the charge of contaminant particles within the enclosure.

19. A method of lifting and transporting a wafer (81) having a top surface, a bottom surface, and a perimeter, from a first location to a second location without physically contacting the top or bottom surfaces of the wafer utilizing a source of gas, the method characterized by the steps of:
supporting a pickup wand assembly (43) with at least one arm (41), the wand assembly having a lower plate (295) with a generally planar lower surface (355), at least one first outlet (368) disposed centrally in and oriented normal to the lower surface of the plate, and a plurality of second outlets (375, 381) arranged in a predetermined pattern around the lower surface of the plate, wherein the plurality of second outlets includes at least one outlet (381) oriented generally toward the arm and at least one outlet (375) oriented generally away from the arm;
communicating gas from the source of gas to the first and second outlets through a gas distribution path (323, 325, 327, 329, 331) within the wand assembly;
expelling gas from the first outlet to develop a low pressure environment above the wafer and establish an omni-directional flow of gas across the wafer; and
expelling gas from the second outlets to develop a low pressure environment above the wafer and establish a plurality of streams of gas flow toward the perimeter of the wafer, with more gas being expelled toward the arm than away from the arm to impart a net frictional force on the wafer in the direction of the arm.

20. The method of Claim 19, wherein the plurality of second outlets (375, 381) includes at least two outlets (381) oriented generally toward the arm (41) and at least one outlet (375) oriented generally away from the arm, and wherein the outlets oriented toward the arm outnumber the outlets oriented away from the arm, and said step of expelling more gas toward the arm than away from the arm includes expelling approximately the same amount of gas through each of said second apertures.

21. The method of Claim 19, including the step of: limiting the movement of the wafer (81) in the direction of the arm.

22. The method of Claim 19, including the step of:
selecting a gas received by the first and second outlets (375, 381) from a choice of at least two sources of gasses.

23. The method of Claim 19, wherein the lower plate (295) has a planar upper surface (298) and the pickup wand assembly (43) comprises an upper plate (293) having a generally planar lower surface (333) juxtaposed over the upper surface of the lower plate, the method further comprising the steps of:
directing a gas through a gas inlet aperture (319) in the upper plate and thereafter into a reservoir groove (329) formed in the lower surface of the upper plate; and
distributing the gas from the reservoir groove into a plurality of gas distribution grooves (323, 325, 327, 329, 331) formed in the lower surface of the upper plate, the gas distribution grooves being in fluid communication with the first and second outlets (375, 381).

24. The method of Claim 19, wherein the at least one arm (41) is hollow for conveying a gas flow from the source of gas, the method further comprising the step of:
channeling the flow of gas received from the hollow arm through the gas distribution path (323, 325, 327, 329, 331) to the first and the second outlets (375, 381).

25. The method of Claim 24, further including intercepting particles in the gas flow through the hollow arm (41) with a filter (229) disposed in the hollow arm.

26. The method of Claim 19, wherein the at least one arm (41) comprises a pair of articulated robot arms, at least one being hollow, the method further comprising the steps of:
supplying gas under pressure from the gas source through the hollow arm of the pair of robot arms to the gas distribution path (323, 325, 327, 329, 331) in the wand assembly (43); and
channeling the gas received from the hollow arm through the gas distribution path to the first and the second outlets (375, 381).

27. The method of Claim 19, wherein the at least one arm (41) comprises a pair of articulated robot arms, each of the pair of arms having a first end portion (139, 141) and a second end portion (199, 201) connected at a swiveling joint (193), and wherein the pickup wand assembly (43) is supported by the second end portion of each arm of the pair of robot arms, the method further comprising the steps of:
providing a drive assembly (101) attached to the first end portions of the robot arms having a drive means; and
imparting rotary motion from the drive means to the first end portions for retracting and extending the wand assembly and for rotating the robot arms to pick up and deliver the wafer (81) from the first location to the second location.

28. The method of Claim 19, including the steps of:
enclosing the wand assembly (43) and the arm in an enclosure (23) in fluid communication with the first and second locations between which the wafer (81) may be transported; and
irradiating the enclosure with a source of UV radiation (557) to neutralize the charge of contaminant particles within the enclosure.

## Patentansprüche

1. Wafer-Handhabungs- und -Transportgerät (21) zum Anheben und Halten eines Wafers (81) mit gegenüberliegenden Ober- und Unterseiten und einem Waferrand, ohne die Ober- oder die Unterseite des Wafers körperlich zu berühren, und Transportieren des Wafers von einer ersten Stelle zu einer zweiten Stelle unter Ausnutzung einer Gasquelle und eines durch mindestens einen Arm (41) gehaltenen Aufnahme-Greifaufbaus (43), gekennzeichnet durch:
den Aufnahme-Greifaufbau, der eine untere Platte (295) mit einer im allgemeinen planaren Unterseite (355) aufweist;
einen Gasverteilungsweg (323, 325, 327, 329, 331) innerhalb des Greifaufbaus;
zumindest einen ersten Auslaß (368), der mittig in der Unterseite der unteren Platte angeordnet und im wesentlichen senkrecht zu ihr orientiert ist, um Gas von der Gasquelle durch den Gasverteilungsweg zu empfangen und das Gas aus der Unterseite auszustoßen, um eine Unterdruckumgebung oberhalb des Wafers zu entwickeln und einen omnidirektionalen Gasstrom über den Wafer beim Halten des Wafers einzurichten; und
eine Vielzahl von zweiten Auslässen (375, 381), die in der Unterseite der unteren Platte und in einem vorbestimmten Muster angeordnet sind, um Gas von der Gasquelle durch den Gasverteilungsweg zu empfangen und das Gas aus der Unterseite auszustoßen, um oberhalb des Wafers eine Unterdruckumgebung zu entwickeln und mehrere Ströme eines Gasstroms zum Rand des Wafers hin einzurichten, worin die Vielzahl von zweiten Auslässen zumindest einen, im allgemeinen zum Arm hin orientierten Auslaß (381) und einen, im allgemeinen vom Arm weg orientierten Auslaß (375) enthält und die Vielzahl von zweiten Auslässen so angeordnet ist, daß mehr Gas zum Arm hin als vom Arm weg ausgestoßen wird, um auf den Wafer in der Richtung des Arms eine Nettoreibungskraft auszuüben.

2. Gerät nach Anspruch 1, worin die Vielzahl von zweiten Auslässen zumindest zwei, im allgemeinen zum Arm hin orientierte Auslässe (381) und zumindest einen, im allgemeinen vom Arm weg orientierten Auslaß (375) enthält und worin die zum Arm hin orientierten Auslässe die vom Arm weg orientierten Auslässe an Zahl übertreffen.

3. Gerät nach Anspruch 1 oder 2, das zumindest eine unter der planaren Unterseite (355) verlaufende Positioniereinrichtung (543) am Greifaufbau (43) zum Berühren des Randes eines angehobenen Wafers (81) und Begrenzen der Bewegung des Wafers in der Richtung des Arms enthält.

4. Gerät nach Anspruch 1, worin der Gasverteilungsweg (323, 325, 327, 329, 331) eine Vielzahl von im Greifaufbau (43) angeordneten, miteinander verbindenden Durchgängen enthält, um jeden der ersten und zweiten Auslässe (375, 381) miteinander zu verbinden.

5. Gerät nach Anspruch 1, worin das Gerät eine Ventileinrichtung zum Auswählen eines durch den Greifaufbau (43) empfangenen Gases aus einer Auswahl von zwei Gasquellen enthält.

6. Gerät nach Anspruch 1 oder 5, worin die untere Platte (295) eine planare Oberseite (298) aufweist und der Greifaufbau (43) ferner aufweist:
eine obere Platte (293) mit einer im allgemeinen planaren Unterseite (333), die über der Oberseite der unteren Platte angelagert ist;
ein Gaseinlaßloch (319) in der oberen Platte, das dazu bestimmt ist, den Ausstrom von Gas von der Gasquelle zu empfangen, wobei das Einlaßloch mit einer in der Unterseite der oberen Platte ausgebildeten Reservoirrille (329) in Fluidverbindung steht; und
eine Vielzahl von Gasverteilungsrillen (323, 325, 327, 329, 331), die in der Unterseite der oberen Platte in Fluidverbindung mit der Reservoirrille und mit den ersten und zweiten Auslässen (375, 381) ausgebildet sind.

7. Gerät nach Anspruch 6, worin die untere (295) und die obere (293) Platte aus Quarz bestehen.

8. Gerät nach Anspruch 1 oder 7, worin der Arm (41) aus rostfreiem Stahl besteht.

9. Gerät nach Anspruch 6, worin die Vielzahl von Gasverteilungsrillen (323, 325, 327, 329, 331) in einem Dreieckmuster mit einem Scheitel zum Arm (41) hin und einer zentralen halbierenden Rille angeordnet ist, wobei das Dreieck über dem Wafer (81) zentriert ist, worin die zweiten Auslässe (375, 381) in der unteren Platte in Verbindung mit dem dreieckigen Muster von Rillen und der zentralen Rille verteilt sind und worin sich der erste Auslaß (368) in der unteren Platte in Ausrichtung mit der zentralen Rille befindet.

10. Gerät nach Anspruch 6, worin die untere Platte (295) des Greifaufbaus (43) geneigte Kanäle (373, 379) enthält, die die Gasverteilungsrillen (323, 325, 327, 329, 331) mit den zweiten Auslässen (375, 381) verbinden, wobei die Kanäle geneigt sind, um einen Gasstrom von den zweiten Auslässen zum Rand des Wafers (81) hin zu leiten.

11. Gerät nach Anspruch 1, worin der zumindest eine Arm (41) hohl ist, um einen Gasstrom dort hindurch zu befördern, und worin der Aufnahme-Greifaufbau (43) eine Einrichtung (207, 209, 211) zum Empfangen eines Gasstroms vom Arm zur Abgabe an die ersten und zweiten Auslässe (375, 381) enthält.

12. Gerät nach Anspruch 11, das ferner einen Filter (229) enthält, der im hohlen Arm (41) angeordnet ist, um Partikel im Gasstrom durch den Arm abzufangen.

13. Gerät nach Anspruch 1, worin die Empfangseinrichtung (207, 209, 211) des Aufnahme-Greifaufbaus (43) einen Filter (261) zum Abfangen von Partikeln im Gasstrom durch den Arm (41) enthält.

14. Gerät nach Anspruch 1, worin der zumindest eine Arm (41) ein Paar gegliederte Roboterarme aufweist, wobei mindestens einer hohl ist, um einen Gasstrom dort hindurch zu befördern, und der Aufnahme-Greifaufbau (43) eine Einrichtung (207, 209, 211) zum Empfangen eines Gasstroms von dem zumindest einen hohlen Roboterarm zur Abgabe an die ersten und zweiten Auslässe (375, 381) enthält.

15. Gerät nach Anspruch 14, worin jeder der Roboterarme (41) einen ersten Endteil (139, 141) und einen zweiten Endteil (199, 201) enthält, die an einer Gelenkverbindung (193) gekoppelt sind, und worin der Aufnahme-Greifaufbau (43) durch den zweiten Endteil jedes Arms des Paars Roboterarme gehalten wird.

16. Gerät nach Anspruch 15, das einen an den ersten Endteilen (139, 141) der Roboterarme (41) angebrachten Antriebsaufbau (101) mit einer Antriebseinrichtung enthält, um den ersten Endteilen eine Drehbewegung zum Zurückziehen und Ausfahren des Aufnahme-Greifaufbaus (43) und zum Drehen der Roboterarme zu erteilen, um den Wafer (81) von der ersten Stelle aufzunehmen und zur zweiten Stelle zu befördern.

17. Gerät nach Anspruch 1, worin der Aufnahme-Greifaufbau (43) am Arm (41) zum selektiven Ersetzen eines Aufnahme-Greifaufbaus für eine Größe durch einen anderen abnehmbar angebracht ist, um die Handhabung und den Transport von Wafern (81) verschiedener Größe zu ermöglichen.

18. Gerät nach Anspruch 1, das ein Gehäuse (23) zum Unterbringen des Greifaufbaus (43) und des Arms (41) in Fluidverbindung mit den ersten und zweiten Stellen, zwischen denen der Wafer (81) transportiert werden kann, und eine Quelle für UV-Strahlung (557) zum Bestrahlen des Gehäuses enthält, um die Ladung von Schmutzpartikeln innerhalb des Gehäuses zu neutralisieren.

19. Verfahren zum Anheben und Transportieren eines Wafers (81) mit einer Oberseite, einer Unterseite und einem Rand von einer ersten Stelle zu einer zweiten Stelle, ohne die Ober- oder die Unterseite des Wafers körperlich zu berühren, unter Ausnutzung einer Gasquelle, wobei das Verfahren gekennzeichnet ist durch die Schritte:
Halten des Aufnahme-Greifaufbaus (43) mit mindestens einem Arm (41), wobei der Greifaufbau eine untere Platte (295) mit einer im allgemeinen planaren Unterseite (355), mindestens einem ersten Auslaß (368), der mittig in der Unterseite der Platte angeordnet und senkrecht zu ihr orientiert ist, und einer Vielzahl von zweiten Auslässen (375, 381) aufweist, die in einem vorbestimmten Muster um die Unterseite der Platte angeordnet sind, worin die Vielzahl von zweiten Auslässen zumindest einen, im allgemeinen zum Arm hin orientierten Auslaß (381) und zumindest einen, im allgemeinen vom Arm weg orientierten Auslaß (375) enthält;
Leiten von Gas von der Gasquelle durch einen Gasverteilungsweg (323, 325, 327, 329, 331) innerhalb des Greifaufbaus zu den ersten und zweiten Auslässen;
Ausstoßen von Gas aus dem ersten Auslaß, um oberhalb des Wafers eine Unterdruckumgebung zu entwickeln und einen omnidirektionalen Gasstrom über den Wafer einzurichten; und
Ausstoßen von Gas aus den zweiten Auslässen, um eine Unterdruckumgebung oberhalb des Wafers zu entwickeln und eine Vielzahl von Strömen eines Gasstroms zum Rand des Wafers hin einzurichten, wobei mehr Gas zum Arm hin als vom Arm weg ausgestoßen wird, um auf den Wafer in der Richtung des Arms eine Nettoreibungskraft auszuüben.

20. Verfahren nach Anspruch 19, worin die Vielzahl von zweiten Auslässen (375, 381) mindestens zwei, im allgemeinen zum Arm (41) hin orientierte Auslässe (381) und mindestens einen, im allgemeinen vom Arm weg orientierten Auslaß (375) enthält und worin die zum Arm hin orientierten Auslässe die vom Arm weg orientierten Auslässe an Zahl übertreffen und der Schritt, bei dem mehr Gas zum Arm hin als vom Arm weg ausgestoßen wird, ein Ausstoßen von ungefähr der gleichen Menge an Gas durch jedes der zweiten Löcher einschließt.

21. Verfahren nach Anspruch 19, den Schritt enthaltend:
Begrenzen der Bewegung des Wafers (81) in der Richtung des Arms.

22. Verfahren nach Anspruch 19, den Schritt enthaltend:
Auswählen eines durch die ersten und zweiten Auslässe (375, 381) empfangenen Gases aus einer Auswahl von mindestens zwei Gasquellen.

23. Verfahren nach Anspruch 19, worin die untere Platte (295) eine planare Oberseite (298) aufweist und der Aufnahme-Greifaufbau (43) eine obere Platte (293) mit einer im allgemeinen planaren Unterseite (333) aufweist, die über der Oberseite der unteren Platte angelagert ist, wobei das Verfahren ferner die Schritte aufweist:
Leiten eines Gases durch ein Gaseinlaßloch (319) in der oberen Platte und danach in eine Reservoirrille (329), die in der Unterseite der oberen Platte ausgebildet ist; und
Verteilen des Gases von der Reservoirrille in eine Vielzahl von Gasverteilungsrillen (323, 325, 327, 329, 331), die in der Unterseite der oberen Platte ausgebildet sind, wobei die Gasverteilungsrillen mit den ersten und zweiten Auslässen (375, 381) in Fluidverbindung stehen.

24. Verfahren nach Anspruch 19, worin der zumindest eine Arm (41) hohl ist, um einen Gasstrom von der Gasquelle zu befördern, wobei das Verfahren ferner den Schritt aufweist:
Kanalisieren des Gasstroms, der vom hohlen Arm empfangen wird, durch den Gasverteilungsweg (323, 325, 327, 329, 331) zu den ersten und den zweiten Auslässen (375, 381).

25. Verfahren nach Anspruch 24, ferner einschließend ein Abfangen von Partikeln im Gasstrom durch den hohlen Arm (41) mit einem im hohlen Arm angeordneten Filter (229).

26. Verfahren nach Anspruch 19, worin der zumindest eine Arm (41) ein Paar gegliederte Roboterarme aufweist, wobei mindestens einer hohl ist, ferner mit den Schritten:
Zuführen von Gas unter Druck von der Gasquelle durch den hohlen Arm des Paars Roboterarme zum Gasverteilungsweg (323, 325, 327, 329, 331) im Greifaufbau (43); und
Kanalisieren des vom hohlen Arm empfangenen Gases durch den Gasverteilungsweg zu den ersten und den zweiten Auslässen (375, 381).

27. Verfahren nach Anspruch 19, worin der zumindest eine Arm (41) ein Paar gegliederte Roboterarme aufweist, wobei jeder der beiden Arme einen ersten Endteil (139, 141) und einen zweiten Endteil (199, 201) aufweist, die an einer Gelenkverbindung (193) gekoppelt sind, und worin der Aufnahme-Greifaufbau (43) durch den zweiten Endteil jedes Arms des Paars Roboterarme gehalten wird, wobei das Verfahren ferner die Schritte aufweist:
Vorsehen eines an den ersten Endteilen der Roboterarme angebrachten Antriebsaufbaus (101) mit einer Antriebseinrichtung; und
Erteilen einer Drehbewegung, von der Antriebseinrichtung, den ersten Endteilen zum Zurückziehen und Ausfahren des Greifaufbaus und zum Drehen der Roboterarme, um den Wafer (81) von der ersten Stelle aufzunehmen und zur zweiten Stelle zu befördern.

28. Verfahren nach Anspruch 19, die Schritte enthaltend:
Einschließen des Greifaufbaus (43) und des Arms in einem Gehäuse (23) in Fluidverbindung mit den ersten und den zweiten Stellen, zwischen denen der Wafer (81) transportiert werden kann; und
Bestrahlen des Gehäuses mit einer Quelle für UV-Strahlung (557), um die Ladung von Schmutzpartikeln innerhalb des Gehäuses zu neutralisieren.

## Revendications

1. Dispositif de maniement et de transport de plaquettes à gravure (21) pour soulever et retenir une plaquette (81) présentant des surfaces opposées supérieure et inférieure et un périmètre de plaquette, sans toucher physiquement lesdites surfaces supérieure ou inférieure de la plaquette, et pour transporter la plaquette d'un premier emplacement à un second emplacement en utilisant une source de gaz et un ensemble formant organe de préhension (43) porté par au moins un bras (41), caractérisé :
en ce que l'ensemble formant organe de préhension comporte une plaque inférieure (295) pourvue d'une surface inférieure (355) globalement plane ;
et par un circuit de distribution de gaz (323, 325, 327, 329, 331) à l'intérieur de l'ensemble formant organe de préhension ;
au moins un premier orifice de sortie (368) disposé de manière centrale dans la surface inférieure de la plaque inférieure et suivant une orientation essentiellement normale par rapport à ladite surface, pour recevoir du gaz provenant de la source de gaz par l'intermédiaire du circuit de distribution de gaz, et pour évacuer ce gaz de la surface inférieure afin de former un environnement à basse pression au-dessus de la plaquette et d'établir un écoulement de gaz omnidirectionnel d'un bout à l'autre de la plaquette en retenant celle-ci ; et
une pluralité de seconds orifices de sortie (375, 381) disposés dans la surface inférieure de la plaque inférieure suivant un modèle prédéterminé, pour recevoir du gaz provenant de la source de gaz par l'intermédiaire du circuit de distribution de gaz, et pour évacuer ce gaz de la surface inférieure afin de former un environnement à basse pression au-dessus de la plaquette et d'établir une pluralité de courants d'écoulement de gaz vers le périmètre de la plaquette, étant précisé que la pluralité de seconds orifices de sortie comprend au moins un orifice de sortie (381) orienté globalement vers le bras, et au moins un orifice de sortie (375) orienté globalement à l'opposé du bras, et est disposée de manière à évacuer plus de gaz en direction du bras que dans la direction opposée, afin de transmettre une force de friction nette à la plaquette, dans la direction du bras.

2. Dispositif selon la revendication 1, dans lequel la pluralité de seconds orifices de sortie comprend au moins deux orifices de sortie (381) orientés globalement vers le bras, et au moins un orifice de sortie (375) orienté globalement à l'opposé du bras, et dans lequel les orifices de sortie orientés vers le bras sont plus nombreux que les orifices de sortie orientés à l'opposé du bras.

3. Dispositif selon la revendication 1 ou 2, comportant sur l'ensemble formant organe de préhension (43) au moins un organe de repérage (543) qui s'étend au-dessous de la surface inférieure plane (355) afin de toucher le périmètre d'une plaquette (81) soulevée et de limiter le mouvement de la plaquette dans la direction du bras.

4. Dispositif selon la revendication 1, dans lequel le circuit de distribution de gaz (323, 325, 327, 329, 331) comporte une pluralité de passages de liaison disposés dans l'ensemble formant organe de préhension (43) afin de relier entre eux le premier et les seconds orifices de sortie (375, 381).

5. Dispositif selon la revendication 1, comportant des moyens formant soupape pour sélectionner un gaz reçu par l'ensemble formant organe de préhension (43) à partir d'un choix de deux sources de gaz.

6. Dispositif selon la revendication 1 ou 5, dans lequel la plaque inférieure (295) a une surface supérieure plane (298) et l'ensemble formant organe de préhension (43) comprend par ailleurs :
une plaque supérieure (293) présentant une surface inférieure (333) globalement plane disposée sur la surface supérieure de la plaque inférieure ;
une ouverture d'admission de gaz (319) prévue dans la plaque supérieure et apte à recevoir l'écoulement de gaz provenant de la source de gaz, l'ouverture d'admission communiquant, pour une circulation de fluide, avec une rainure formant réservoir (329) formée dans la surface inférieure de la plaque supérieure ; et
une pluralité de rainures de distribution de gaz (323, 325, 327, 329, 331) formées dans la surface inférieure de la plaque supérieure et communiquant, pour une circulation de fluide, avec la rainure formant réservoir et avec le premier et les seconds orifices de sortie (375, 381).

7. Dispositif selon la revendication 6, dans lequel les plaques inférieure (295) et supérieure (293) sont en quartz.

8. Dispositif selon la revendication 1 ou 7, dans lequel le bras (41) est en acier inoxydable.

9. Dispositif selon la revendication 6, dans lequel la pluralité de rainures de distribution de gaz (323, 325, 327, 329, 331) est disposée suivant une forme triangulaire avec un sommet dirigé vers le bras (41) et une rainure bissectrice centrale, le triangle étant centré au-dessus de la plaquette (81), dans lequel les seconds orifices de sortie (375, 381) sont répartis dans la plaque inférieure en communiquant avec la forme triangulaire des rainures et de la rainure centrale, et dans lequel le premier orifice de sortie (368) est situé, sur la plaque inférieure, dans l'alignement de la rainure centrale.

10. Dispositif selon la revendication 6, dans lequel la plaque inférieure (295) de l'ensemble formant organe de préhension (43) comporte des canaux inclinés (373, 379) qui relient les rainures de distribution de gaz (323, 325, 327, 329, 331) aux seconds orifices de sortie (375, 381), ces canaux étant inclinés pour diriger l'écoulement de gaz des seconds orifices de sortie vers le périmètre de la plaquette (81).

11. Dispositif selon la revendication 1, dans lequel le ou les bras (41) sont creux afin de transporter un écoulement de gaz, et dans lequel l'ensemble formant organe de préhension (43) comporte des moyens (207, 209, 211) pour recevoir un écoulement de gaz provenant du bras et le transmettre au premier et aux seconds orifices de sortie (375, 381).

12. Dispositif selon la revendication 11, comportant également un filtre (229) disposé dans le bras creux (41) et destiné à intercepter les particules contenues dans l'écoulement de gaz qui traverse le bras.

13. Dispositif selon la revendication 11, dans lequel les moyens de réception (207, 209, 211) de l'ensemble formant organe de préhension (43) comportent un filtre (261) destiné à intercepter les particules contenues dans l'écoulement de gaz qui traverse le bras.

14. Dispositif selon la revendication 1, dans lequel le ou les bras (41) comportent une paire de bras de robot articulés, l'un au moins des bras étant creux afin de transporter un écoulement de gaz, et l'ensemble formant organe de préhension (43) comporte des moyens (207, 209, 211) destinés à recevoir un écoulement de gaz provenant du ou des bras de robot creux et à le transmettre au premier et aux seconds orifices de sortie (375, 381).

15. Dispositif selon la revendication 14, dans lequel chacun des bras de robot (41) comporte une première partie d'extrémité (139, 141) et une seconde partie d'extrémité (199, 201) reliées au niveau d'un joint pivotant (193), et dans lequel l'ensemble formant organe de préhension (43) est supporté par la seconde partie d'extrémité de chaque bras de la paire de bras de robot.

16. Dispositif selon la revendication 15, comportant un ensemble de commande (101) fixé aux premières parties d'extrémité (139, 141) des bras de robot (41) et comportant des moyens de commande destinés à imprimer un mouvement rotatif aux premières parties d'extrémité afin de rétracter et de déployer l'ensemble formant organe de préhension (43) et de faire tourner les bras de robot en vue de prendre la plaquette (81) et de la faire passer du premier emplacement au second.

17. Dispositif selon la revendication 1, dans lequel l'ensemble formant organe de préhension (43) est fixé de façon amovible au bras (41) pour permettre de remplacer sélectivement un ensemble formant organe de préhension d'une taille par un autre, afin de permettre le maniement et le transport de plaquettes (81) de différentes tailles.

18. Dispositif selon la revendication 1, comportant une enveloppe (23) destinée à loger l'ensemble formant organe de préhension (43) et le bras (41) en liaison, pour une circulation de fluide, avec le premier et le second emplacement entre lesquels la plaquette (81) peut être transportée, et une source de rayonnement UV (557) destinée à exposer le boîtier à un rayonnement afin de neutraliser la charge de particules contaminatrices à l'intérieur de l'enveloppe.

19. Méthode pour soulever et transporter d'un premier emplacement à un second emplacement une plaquette (81) présentant une surface supérieure, une surface inférieure et un périmètre, sans toucher physiquement lesdites surfaces supérieure ou inférieure de la plaquette, en utilisant une source de gaz, caractérisée en ce qu'elle consiste :
à supporter un ensemble formant organe de préhension (43) à l'aide d'au moins un bras (41), ledit ensemble (43) comportant une plaque inférieure (295) pourvue d'une surface inférieure (355) globalement plane, au moins un premier orifice de sortie (368) disposé de manière centrale dans la surface inférieure de ladite plaque et suivant une orientation normale par rapport à ladite surface, et une pluralité de seconds orifices de sortie (375, 381) disposés suivant un modèle prédéterminé autour de la surface inférieure de la plaque, étant précisé que la pluralité de seconds orifices de sortie comprend au moins un orifice de sortie (381) orienté globalement vers le bras et au moins un orifice de sortie (375) orienté globalement à l'opposé du bras ;
à amener du gaz, à partir de la source de gaz, vers le premier et les seconds orifices de sortie par un circuit de distribution de gaz (323, 325, 327, 329, 331) prévu à l'intérieur de l'ensemble formant organe de préhension ;
à évacuer le gaz par le premier orifice de sortie pour former un environnement à basse pression au-dessus de la plaquette et établir un écoulement de gaz omnidirectionnel d'un bout à l'autre de la plaquette ; et
à évacuer le gaz par les seconds orifices de sortie pour former un environnement à basse pression au-dessus de la plaquette et établir une pluralité de courants d'écoulement de gaz vers le périmètre de la plaquette, la quantité de gaz évacuée vers le bras étant supérieure à la quantité de gaz évacuée dans la direction opposée, afin de transmettre une force de friction nette à la plaquette, dans la direction du bras.

20. Méthode selon la revendication 19, selon laquelle la pluralité de seconds orifices de sortie (375, 381) comprend au moins deux orifices de sortie (381) orientés globalement vers le bras (41), et au moins un orifice de sortie (375) orienté globalement à l'opposé du bras, et selon laquelle les orifices de sortie orientés vers le bras sont plus nombreux que ceux qui sont orientés à l'opposé du bras, et la mesure qui consiste à évacuer plus de gaz vers le bras qu'à l'opposé du bras prévoit l'évacuation de la même quantité de gaz, approximativement, par chacune desdites secondes ouvertures.

21. Méthode selon la revendication 19, consistant à limiter le mouvement de la plaquette (81) dans la direction du bras.

22. Méthode selon la revendication 19, consistant à sélectionner un gaz reçu par le premier et les seconds orifices de sortie (375, 381) à partir d'un choix d'au moins deux sources de gaz.

23. Méthode selon la revendication 19, selon laquelle la plaque inférieure (295) a une surface supérieure plane (298) et l'ensemble formant organe de préhension (43) comporte une plaque supérieure (293) présentant une surface inférieure (333) globalement plane disposée sur la surface supérieure de la plaque inférieure, et consistant également:
à diriger un gaz dans une ouverture d'admission de gaz (319) de la plaque supérieure puis dans une rainure formant réservoir (329) formée dans la surface inférieure de la plaque supérieure ; et
à répartir le gaz provenant de la rainure formant réservoir dans une pluralité de rainures de distribution de gaz (323, 325, 327, 329, 331) formées dans la surface inférieure de la plaque supérieure, les rainures de distribution de gaz communiquant, pour une circulation de fluide, avec le premier et les seconds orifices de sortie (375, 381).

24. Méthode selon la revendication 19, selon laquelle le ou les bras (41) sont creux afin de transporter un écoulement de gaz à partir de la source de gaz, et consistant également :
à canaliser l'écoulement de gaz reçu du bras creux vers le premier et les seconds orifices de sortie (375, 381) par l'intermédiaire du circuit de distribution de gaz (323, 325, 327, 329, 331).

25. Méthode selon la revendication 24, consistant également à intercepter les particules contenues dans l'écoulement de gaz qui traverse le bras creux (41), à l'aide d'un filtre (229) disposé dans celui-ci.

26. Méthode selon la revendication 19, selon laquelle le ou les bras (41) comportent une paire de bras de robot articulés, l'un au moins des bras étant creux, et consistant également :
à amener du gaz sous pression de la source de gaz, par le bras creux de la paire de bras de robot, vers le circuit de distribution de gaz (323, 325, 327, 329, 331) de l'ensemble formant organe de préhension (43) ; et
à canaliser le gaz reçu du bras creux vers le premier et les seconds orifices de sortie (375, 381) par l'intermédiaire du circuit de distribution de gaz.

27. Méthode selon la revendication 19, selon laquelle le ou les bras (41) comportent une paire de bras de robot articulés qui présentent chacun une première partie d'extrémité (139, 141) et une seconde partie d'extrémité (199, 201) reliées au niveau d'un joint pivotant (193), et selon laquelle l'ensemble formant organe de préhension (43) est supporté par la seconde partie d'extrémité de chaque bras de la paire de bras de robot, et consistant également :
à prévoir un ensemble de commande (101) fixé aux premières parties d'extrémité des bras de robot et comportant des moyens de commande ; et
à transmettre à partir des moyens de commande un mouvement rotatif aux premières parties d'extrémité afin de rétracter et de déployer l'ensemble formant organe de préhension et de faire tourner les bras de robot en vue de prendre la plaquette (81) et de la faire passer du premier emplacement au second.

28. Méthode selon la revendication 19, consistant :
à enfermer l'ensemble formant organe de préhension (43) et le bras dans une enveloppe (23) qui communique, pour une circulation de fluide, avec le premier et le second emplacement entre lesquels la plaquette (81) peut être transportée ; et
à exposer l'enveloppe au rayonnement d'une source de rayonnement UV (557) afin de neutraliser la charge de particules contaminatrices à l'intérieur de l'enveloppe.
